# EUROPEAN PATENT APPLICATION

(11) **EP 4 800 926 A1**
(43) Date of publication of application: **02.09.2026**
(21) Application number: 24893252.7
(22) Date of filing: 07.11.2024
(51) Int. Cl.: H03M 7/30, G06F 16/174

(54) **DATA PROCESSING METHOD AND APPARATUS, AND DEVICE AND COMPUTER-READABLE STORAGE MEDIUM**

(30) Priority: 20.11.2023 CN 202311559827; 19.03.2024 CN 202410315918
(71) Applicant: Huawei Cloud Computing Technologies Co., Ltd., Gui'an New District, Guizhou 550025 (CN)
(72) Inventor: FENG, Ke, Guiyang, Guizhou 550025 (CN); DENG, Kaiwen, Guiyang, Guizhou 550025 (CN)
(74) Representative: Epping - Hermann - Fischer
(86) International application number: PCT/CN2024/130491
(87) International publication number: WO 2025/108094

(57) **Abstract**

This application discloses a data processing method and apparatus, a device, and a computer-readable storage medium, and relates to the field of cloud computing technologies. In this application, a data processing instruction instructing to decompress first compressed data to obtain target data is obtained, where the first compressed data is obtained by compressing a data group to which the target data belongs, and the data processing instruction includes a first start location of the target data in the data group and a length of the target data; a second start location of second compressed data that is in the first compressed data and that is decompressed to obtain the target data is determined based on the first start location and a reference distance, where the reference distance indicates a maximum value of a distance between any data segment in the target data and a data segment referenced by the any data segment; and the second compressed data is decompressed based on the second start location and an end location of the second compressed data to obtain the target data, where the end location is determined based on the first start location and the length of the target data. In this application, a clear decompression boundary can be provided before decompression, improving decompression accuracy.

## Description

This application claims priorities to Chinese Patent Application No. 202311559827.1, filed on November 20, 2023 and entitled "DATA PROCESSING METHOD AND APPARATUS, DEVICE, AND COMPUTER-READABLE STORAGE MEDIUM", and to Chinese Patent Application No. 202410315918.9, filed on March 19, 2024 and entitled "DATA PROCESSING METHOD AND APPARATUS, DEVICE, AND COMPUTER-READABLE STORAGE MEDIUM", both of which are incorporated herein by reference in their entireties.

### TECHNICAL FIELD

This application relates to the field of cloud computing technologies, and in particular, to a data processing method and apparatus, a device, and a computer-readable storage medium.

### BACKGROUND

With the development of cloud computing technologies, computing capabilities of cloud computing are gradually improved, an amount of data needed in a computational process is increasing, and an amount of data that needs to be stored is growing accordingly. In this case, in a data storage process, data may be compressed, and compressed data is stored, to reduce data storage costs. When there is a compute requirement for the stored data, the compressed data needs to be first decompressed to obtain data before compression, and computing is performed on the data before compression to meet the compute requirement.

### SUMMARY

This application provides a data processing method and apparatus, a device, and a computer-readable storage medium, to provide a clear decompression boundary and implement precise decompression. Technical solutions are as follows.

According to a first aspect, a data processing method is provided. The method includes: obtaining a data processing instruction, where the data processing instruction instructs to decompress first compressed data to obtain target data, the first compressed data is obtained by compressing a data group to which the target data belongs, and the data processing instruction includes a first start location of the target data in the data group and a length of the target data; determining a second start location of second compressed data in the first compressed data based on the first start location and a reference distance, where the second compressed data is decompressed to obtain the target data, and the reference distance indicates a maximum value of a distance between any data segment in the target data and a data segment referenced by the any data segment; and decompressing the second compressed data based on the second start location and an end location of the second compressed data to obtain the target data, where the end location of the second compressed data is determined based on the first start location and the length of the target data.

Because the reference distance indicates a maximum value of a distance between any data segment in the target data and a data segment referenced by the any data segment, a data segment referenced by each data segment in the target data may be in the target data, or may be in partial data whose distance to the first start location is less than or equal to the reference distance. Therefore, the second start location of the second compressed data decompressed to obtain the target data can be determined based on the first start location and the reference distance, and it is ensured that the target data can be obtained by decompressing the second compressed data from the second start location. In addition, the end location of the second compressed data can be accurately determined based on the first start location and the length of the target data, and decompression is stopped at the end location of the second compressed data. Decompression performed by using the determined second start location and the determined end location of the second compressed data as a decompression boundary not only can ensure that data obtained through decompression includes the target data, but also can reduce decompression of compressed data that does not need to be decompressed, thereby improving decompression efficiency and accuracy and reducing a waste of resources.

In a possible implementation, the first compressed data includes a plurality of compressed segments, the data group includes a plurality of data segments, and each compressed segment is obtained by compressing a corresponding data segment; and determining the second start location of the second compressed data in the first compressed data based on the first start location and the reference distance includes: obtaining a start location of each data segment in the data group; determining, in the plurality of data segments based on the start location of each data segment, a first data segment to which a first location belongs, where the first location is determined based on a difference between the first start location and the reference distance; determining, based on a start location of the first data segment, a start location of a first compressed segment corresponding to the first data segment; and determining the start location of the first compressed segment as the second start location.

Because the difference between the first start location and the reference distance can indicate the first location that is before the first start location and whose distance to the first start location is the reference distance, and a distance between any data segment in the target data and a data segment referenced by the any data segment is less than or equal to the reference distance, in other words, a data segment referenced by any data segment in a target data segment is at the first location or after the first location, decompression starts from the start location of the first compressed segment corresponding to the first data segment to which the first location belongs. This can ensure that the target data is obtained through decompression.

In a possible implementation, obtaining the start location of each data segment in the data group includes: obtaining a length of each data segment; and determining the start location of each data segment in the data group based on the length of each data segment and an order of each compressed segment in the first compressed data, where an order of any data segment in the data group is the same as an order of a compressed segment that is in the first compressed data and that is obtained by compressing the any data segment.

Because the order of the any data segment in the data group is the same as the order of the compressed segment that is in the first compressed data and that is obtained by compressing the any data segment, an order of each data segment in the data group may be determined based on the order of each compressed segment in the first compressed data, and an initial location of each data segment in the data group can be accurately determined based on the length of each data segment and the order of each data segment in the data group.

In a possible implementation, determining, based on the start location of the first data segment, the start location of the first compressed segment corresponding to the first data segment includes: obtaining mapping information, where the mapping information indicates mapping relationships between start locations of the plurality of data segments and start locations of the plurality of compressed segments; and determining the start location of the first compressed segment based on the mapping information and the start location of the first data segment. Because the mapping information can indicate the mapping relationships between the start locations of the plurality of data segments and the start locations of the plurality of compressed segments, and the first data segment belongs to the plurality of data segments, the start location of the first compressed segment corresponding to the first data segment can be accurately determined based on the mapping information.

In a possible implementation, the mapping information includes a start location of at least one reference data segment in the plurality of data segments and a start location of at least one reference compressed segment obtained by compressing the at least one reference data segment; and determining the start location of the first compressed segment based on the mapping information and the start location of the first data segment includes: determining a first reference data segment in the at least one reference data segment based on the start location of the first data segment and the start location of the at least one reference data segment, where the first reference data segment is a reference data segment that is before the first data segment and that is closest to the first data segment; and determining, as the start location of the first compressed segment, a start location of a first reference compressed segment obtained by compressing the first reference data segment. The mapping information stores the start location of the at least one reference data segment and the start location of the at least one reference compressed segment, so that memory space needed by the mapping information can be reduced, and a waste of resources can be reduced.

In a possible implementation, before decompressing the second compressed data based on the second start location and the end location of the second compressed data to obtain the target data, the method further includes: determining, in the plurality of data segments based on the start location of each data segment, a second data segment to which a second location belongs, where the second location is a sum of the first start location and the length of the target data; determining, in the start locations of the data segments, a start location of a third data segment adjacent to the second data segment, where the third data segment is after the second data segment; determining, based on the start location of the third data segment, a start location of a second compressed segment corresponding to the third data segment; and determining the start location of the second compressed segment as the end location of the second compressed data.

Because the sum of the first start location and the length of the target data can indicate an end location of the target data in the data group, in other words, the second location can indicate an end location of the target data in the data group, the second data segment to which the second location belongs is a data segment to which the end location of the target data belongs. Therefore, the start location of the third data segment that is adjacent to the second data segment and that is after the second data segment is after the end location of the target data, and decompression is stopped at the start location of the second compressed segment corresponding to the third data segment. In this way, the target data can be completely decompressed.

In a possible implementation, decompressing the second compressed data based on the second start location and the end location of the second compressed data to obtain the target data includes: decompressing the second compressed data based on the second start location and the end location of the second compressed data to obtain intermediate data; determining an end location of the target data based on the first start location and the length of the target data; and extracting the target data from the intermediate data based on the first start location and the end location of the target data. The target data is extracted from the intermediate data based on the first start location of the target data and the end location of the target data. This can ensure that the data obtained through extraction completely matches the target data, and accuracy of the target data obtained through decompression is higher.

In a possible implementation, the data group is stored in a heap-organized table (heap-organized table, HOT), the data group includes a plurality of pieces of data in a storage block of the HOT, and the target data includes at least one piece of data in the plurality of pieces of data. The target data is at least one piece of data in the plurality of pieces of data, that is, the target data is partial data in the data group. Therefore, according to the data processing method provided in this application, the at least one piece of data can be obtained by performing partial decompression on compressed data obtained by compressing the plurality of pieces of data, to ensure decompression accuracy.

In a possible implementation, the data group is stored in a baseline database of a log-structured merge tree (log-structured merge tree, LSM-tree), the data group includes data in a plurality of storage blocks in the baseline database, and the target data includes data in at least one of the plurality of storage blocks. The target data is data in at least one of the plurality of storage blocks, that is, the target data is partial data in the data group. Therefore, according to the data processing method provided in this application, the data in the at least one storage block can be obtained by performing partial decompression on compressed data obtained by compressing the data in the plurality of storage blocks, to ensure decompression accuracy.

According to a second aspect, a data processing method is provided. The method includes: obtaining a data group, where the data group includes a plurality of bytes; dividing the plurality of bytes into a plurality of data segments, where the plurality of data segments include at least one of a matching data segment or a non-matching data segment, a byte in the non-matching data segment is different from a byte in each data segment before the non-matching data segment, a byte in the matching data segment is the same as a byte in a matched data segment before the matching data segment, and a distance between the matching data segment and the matched data segment is less than or equal to a reference distance; and compressing the plurality of data segments based on data segments referenced by the plurality of data segments to obtain first compressed data including a plurality of compressed segments, where each compressed segment is obtained by compressing a corresponding data segment, a data segment referenced by any matching data segment is a matched data segment having a same byte that in the any matching data segment, and a data segment referenced by any non-matching data segment is the any non-matching data segment.

In this application, the distance between the matching data segment and the matched data segment in the data group is controlled to be less than or equal to the reference distance, so that during decompression, decompression of each compressed segment that needs to be decompressed can be implemented based on a compressed segment corresponding to a data segment whose distance to each data segment does not exceed the reference distance. Therefore, before the decompression, a clear boundary of the compressed data that needs to be decompressed is determined based on the reference distance, to implement precise decompression.

In a possible implementation, dividing the plurality of bytes in to the plurality of data segments includes: dividing the plurality of bytes into a plurality of candidate data segments, where the plurality of candidate data segments include at least one of a candidate matching data segment or a non-matching data segment, and a byte in the candidate matching data segment is the same as a byte in at least one candidate matched data segment before the candidate matching data segment; obtaining a location array of the candidate matching data segment, where the location array includes a location of the candidate matching data segment and a location of the at least one candidate matched data segment corresponding to the candidate matching data segment; and in a case in which there is a candidate distance less than or equal to the reference distance in at least one candidate distance, determining the candidate matching data segment as the matching data segment, where the at least one candidate distance is determined based on the location of the candidate matching data segment and the location of the at least one candidate matched data segment; or in a case in which the at least one candidate distance is greater than the reference distance, determining the candidate matching data segment as the non-matching data segment.

In a case in which the at least one candidate distance corresponding to the candidate matching data segment is greater than the reference distance, if the candidate matching data segment is compressed by referencing the candidate matched data segment corresponding to the candidate matching data segment, decompression of the candidate matching data segment cannot be implemented based on a compressed segment corresponding to a data segment whose distance to the candidate matching data segment does not exceed the reference distance. Therefore, in a case in which there is a candidate distance less than or equal to the reference distance in the at least one candidate distance corresponding to the candidate matching data segment, the candidate matching data segment is determined as the matching data segment, and the matching data segment is compressed by referencing a matched data segment whose distance to the matching data segment is less than or equal to the reference distance. This can ensure that a compressed segment corresponding to a data segment whose distance to the matching data segment does not exceed the reference distance is decompressed to obtain the matching data segment, so as to ensure decompression accuracy.

In a possible implementation, after compressing the plurality of data segments based on the data segments referenced by the plurality of data segments, the method further includes: generating mapping information, where the mapping information indicates mapping relationships between start locations of the plurality of data segments and start locations of the plurality of compressed segments. Because the mapping information can indicate the mapping relationships between the start locations of the plurality of data segments and the start locations of the plurality of compressed segments, a start location of a compressed segment corresponding to a start location of any data segment can be efficiently determined based on the mapping information in a decompression process, or a start location of a data segment corresponding to a start location of any compressed segment can be efficiently determined.

In a possible implementation, the data group is stored in a HOT, and the data group includes a plurality of pieces of data in a storage block of the HOT. According to the data processing method provided in this application, the plurality of pieces of data in the storage block are compressed, so that a distance between a matching data segment and a matched data segment in the plurality of pieces of data in the storage block can be controlled to be less than or equal to the reference distance, and when the compressed data obtained by compressing the plurality of pieces of data is decompressed, a clear decompression boundary can be determined based on the reference distance, to ensure decompression accuracy.

In a possible implementation, the data group is stored in a baseline database of an LSM-tree, and the data group includes data in a plurality of storage blocks in the baseline database. According to the data processing method provided in this application, the data in the plurality of storage blocks is compressed, so that a distance between a matching data segment and a matched data segment in the data in the plurality of storage blocks can be controlled to be less than or equal to the reference distance, and when the compressed data obtained by compressing the data in the plurality of storage blocks is decompressed, a clear decompression boundary can be determined based on the reference distance, to ensure decompression accuracy.

According to a third aspect, a data processing apparatus is provided. The apparatus includes: an obtaining module, configured to obtain a data processing instruction, where the data processing instruction instructs to decompress first compressed data to obtain target data, the first compressed data is obtained by compressing a data group to which the target data belongs, and the data processing instruction includes a first start location of the target data in the data group and a length of the target data; a determining module, configured to determine a second start location of second compressed data in the first compressed data based on the first start location and a reference distance, where the second compressed data is decompressed to obtain the target data, and the reference distance indicates a maximum value of a distance between any data segment in the target data and a data segment referenced by the any data segment; and a decompression module, configured to decompress the second compressed data based on the second start location and an end location of the second compressed data to obtain the target data, where the end location of the second compressed data is determined based on the first start location and the length of the target data.

In a possible implementation, the first compressed data includes a plurality of compressed segments, the data group includes a plurality of data segments, and each compressed segment is obtained by compressing a corresponding data segment. The determining module is configured to: obtain a start location of each data segment in the data group; determine, in the plurality of data segments based on the start location of each data segment, a first data segment to which a first location belongs, where the first location is determined based on a difference between the first start location and the reference distance; determine, based on a start location of the first data segment, a start location of a first compressed segment corresponding to the first data segment; and determine the start location of the first compressed segment as the second start location.

In a possible implementation, the determining module is configured to: obtain a length of each data segment; and determine the start location of each data segment in the data group based on the length of each data segment and an order of each compressed segment in the first compressed data, where an order of any data segment in the data group is the same as an order of a compressed segment that is in the first compressed data and that is obtained by compressing the any data segment.

In a possible implementation, the determining module is configured to: obtain mapping information, where the mapping information indicates mapping relationships between start locations of the plurality of data segments and start locations of the plurality of compressed segments; and determine the start location of the first compressed segment based on the mapping information and the start location of the first data segment.

In a possible implementation, the mapping information includes a start location of at least one reference data segment in the plurality of data segments and a start location of at least one reference compressed segment obtained by compressing the at least one reference data segment. The determining module is configured to: determine a first reference data segment in the at least one reference data segment based on the start location of the first data segment and the start location of the at least one reference data segment, where the first reference data segment is a reference data segment that is before the first data segment and that is closest to the first data segment; and determine, as the start location of the first compressed segment, a start location of a first reference compressed segment obtained by compressing the first reference data segment.

In a possible implementation, the determining module is further configured to: determine, in the plurality of data segments based on the start location of each data segment, a second data segment to which a second location belongs, where the second location is a sum of the first start location and the length of the target data; determine, in the start locations of the data segments, a start location of a third data segment adjacent to the second data segment, where the third data segment is after the second data segment; determine, based on the start location of the third data segment, a start location of a second compressed segment corresponding to the third data segment; and determine the start location of the second compressed segment as the end location of the second compressed data.

In a possible implementation, the decompression module is configured to: decompress the second compressed data based on the second start location and the end location of the second compressed data, to obtain intermediate data; determine an end location of the target data based on the first start location and the length of the target data; and extract the target data from the intermediate data based on the first start location and the end location of the target data.

In a possible implementation, the data group is stored in a HOT, the data group includes a plurality of pieces of data in a storage block of the HOT, and the target data includes at least one piece of data in the plurality of pieces of data.

In a possible implementation, the data group is stored in a baseline database of an LSM-tree, the data group includes data in a plurality of storage blocks in the baseline database, and the target data includes data in at least one of the plurality of storage blocks.

According to a fourth aspect, a data processing apparatus is provided. The apparatus includes: an obtaining module, configured to obtain a data group, where the data group includes a plurality of bytes; a division module, configured to divide the plurality of bytes into a plurality of data segments, where the plurality of data segments include at least one of a matching data segment or a non-matching data segment, a byte in the non-matching data segment is different from a byte in each data segment before the non-matching data segment, a byte in the matching data segment is the same as a byte in a matched data segment before the matching data segment, and a distance between the matching data segment and the matched data segment is less than or equal to a reference distance; and a compression module, configured to compress the plurality of data segments based on data segments referenced by the plurality of data segments to obtain first compressed data including a plurality of compressed segments, where each compressed segment is obtained by compressing a corresponding data segment, a data segment referenced by any matching data segment is a matched data segment having a same byte that in the any matching data segment, and a data segment referenced by any non-matching data segment is the any non-matching data segment.

In a possible implementation, the division module is configured to: divide the plurality of bytes into a plurality of candidate data segments, where the plurality of candidate data segments include at least one of a candidate matching data segment or a non-matching data segment, and a byte in the candidate matching data segment is the same as a byte in at least one candidate matched data segment before the candidate matching data segment; obtain a location array of the candidate matching data segment, where the location array includes a location of the candidate matching data segment and a location of the at least one candidate matched data segment corresponding to the candidate matching data segment; and in a case in which there is a candidate distance less than or equal to the reference distance in at least one candidate distance, determine the candidate matching data segment as the matching data segment, where the at least one candidate distance is determined based on the location of the candidate matching data segment and the location of the at least one candidate matched data segment; or in a case in which the at least one candidate distance is greater than the reference distance, determine the candidate matching data segment as the non-matching data segment.

In a possible implementation, the apparatus further includes a generation module, and the generation module is configured to generate mapping information, where the mapping information indicates mapping relationships between start locations of the plurality of data segments and start locations of the plurality of compressed segments.

In a possible implementation, the data group is stored in a HOT, and the data group includes a plurality of pieces of data in a storage block of the HOT.

In a possible implementation, the data group is stored in a baseline database of an LSM-tree, and the data group includes data in a plurality of storage blocks in the baseline database.

According to a fifth aspect, this application provides a compute device cluster. The compute device cluster includes at least one compute device. Each compute device includes a processor and a memory. The processor of the at least one compute device is configured to execute instructions stored in the memory of the at least one compute device, to cause the compute device cluster to perform the data processing method provided in any one of the first aspect or the second aspect and the possible implementations of the first aspect or the second aspect.

According to a sixth aspect, an embodiment of this application provides a computer program product including instructions. When the instructions are run by a compute device cluster, the compute device cluster is caused to perform the data processing method provided in any one of the first aspect or the second aspect and the possible implementations of the first aspect or the second aspect. The computer program product may be a software installation package. When a function of the foregoing compute device cluster needs to be implemented, the computer program product may be downloaded and executed on the compute device cluster.

According to a seventh aspect, an embodiment of this application provides a computer-readable storage medium. The computer-readable storage medium includes computer program instructions. When the computer program instructions are executed by a compute device cluster, the compute device cluster performs the data processing method provided in any one of the first aspect or the second aspect and the possible implementations of the first aspect or the second aspect. The storage medium includes but is not limited to a volatile memory, for example, a random access memory, or a non-volatile memory, for example, a flash memory, a hard disk drive (hard disk drive, HDD), or a solid-state drive (solid-state drive, SSD).

It should be understood that, for beneficial effects achieved by the technical solutions of the third aspect to the seventh aspect and the corresponding possible implementations of the third aspect to the seventh aspect in this application, refer to the technical effects of the data processing method provided in any one of the first aspect or the second aspect and the possible implementations of the first aspect or the second aspect. Details are not described herein again.

### BRIEF DESCRIPTION OF DRAWINGS

FIG. 1 is a schematic flowchart of performing general data compression based on an LZ77 algorithm according to a related technology;
FIG. 2 is a schematic flowchart of performing general data compression based on an LZ77 algorithm according to a related technology;
FIG. 3 is a diagram of an implementation scenario of a data processing method according to an embodiment of this application;
FIG. 4 is a schematic flowchart of a data compression method according to an embodiment of this application;
FIG. 5 is a diagram of a HOT-based data processing environment according to an embodiment of this application;
FIG. 6 is a diagram of an LSM-tree-based data processing environment according to an embodiment of this application;
FIG. 7 is a diagram of mapping information according to an embodiment of this application;
FIG. 8 is a schematic flowchart of data compression according to an embodiment of this application;
FIG. 9 is a schematic flowchart of data decompression according to an embodiment of this application;
FIG. 10 is a diagram of a structure of a data processing apparatus according to an embodiment of this application;
FIG. 11 is a diagram of another structure of a data processing apparatus according to an embodiment of this application;
FIG. 12 is a diagram of a hardware structure of a compute device according to an embodiment of this application;
FIG. 13 is a diagram of a structure of a compute device cluster according to an embodiment of this application; and
FIG. 14 is a diagram of a connection manner of a compute device cluster according to an embodiment of this application.

### DESCRIPTION OF EMBODIMENTS

Terms used in implementations of this application are only used to explain specific embodiments of this application, but are not intended to limit this application.

With the development of cloud computing technologies, cloud services provided based on the cloud computing technologies are increasingly diversified. For complex computing performed for providing cloud services, a large amount of data needs to be invoked in a computational process, and therefore a large amount of data needs to be stored. For example, a data management system like a database is configured to store a large amount of data corresponding to various cloud services, and with the update and development of the cloud services, an amount of data that needs to be stored by the data management system increases correspondingly. However, the data management system needs to continuously expand a system capacity to store increasing data, consuming high storage costs. In addition, the system capacity expansion of the data management system may cause the data management system to be unstable, causing problems such as an error or a loss of stored data.

Therefore, during data storage, a data compression technology is usually used to compress data, so that a volume of compressed data is reduced, and storing the compressed data can reduce data storage costs and reduce frequency and possible risks of system capacity expansion. For example, a group of data may be compressed as a whole by using a data compression technology. For example, a group of user records in a database may be compressed as a whole. The data compression technology may be LZ77 (a data compression technology), a Huffman (Huffman) compression technology, or the like. The LZ77 is a lossless data compression algorithm. The Huffman compression technology is used to compress data by encoding the data.

In a computational process, when it is necessary to compute the compressed data, the compressed data needed for the computing needs to be queried first, the compressed data needed for the computing is decompressed to obtain decompressed data, and the computing is completed based on the decompressed data. A part of the compressed data may be queried in the computational process, in other words, the data that needs to be queried is partial data in a group of compressed data. Therefore, it is unnecessary to decompress all the compressed data, but only the partial compressed data may be decompressed, in other words, the compressed data is partially decompressed to obtain needed partial data.

Because compressed data obtained by compressing data by using different data compression technologies varies, manners of performing partial decompression on different compressed data are different. For example, in a related technology 1, based on a feature of data that needs to be compressed, a data compression technology like dictionary encoding or run length encoding (run length encoding, RLE) is used to compress the data, so that compressed data can support partial decompression.

The dictionary encoding in the related technology 1 is used as an example. In the related technology 1, data that needs to be compressed may be divided into a plurality of independent fields based on a service requirement and a service feature, a repeated field that appears frequently in the plurality of fields is found, a value of the repeated field is stored in an independent data dictionary, and the value of the repeated field in the data that needs to be compressed is replaced with a location of the repeated field in the data dictionary, to obtain compressed data and complete data compression. When the data obtained through compression is decompressed, data restoration may be performed based on the location of the repeated field in the compressed data in the data dictionary and the value in the data dictionary, to complete data decompression. When partial data needs to be decompressed, a location in the data dictionary included in the partial data needs to be restored to a value of a corresponding repeated field, to obtain restored data, so as to decompress the partial data.

However, in the related technology 1, only the repeated field in the data can be identified, and redundant repeated information in the field cannot be identified. Consequently, unidentified repeated information cannot be compressed, a compression ratio of repeated information in the data cannot be ensured, and stability of the compression ratio cannot be ensured. In addition, in the related technology 1, data needs to be divided based on a service requirement and a service feature. However, in some cases, it is difficult to divide data based on the service requirement and the service feature, and the related technology 1 is difficult to be applied to the compression and decompression scenario in this case. Consequently, the technology has poor scenario adaptability.

Another related technology 2 is further provided in the data compression field. In the related technology 2, data that needs to be compressed is divided into a plurality of independent parts, and each part is separately compressed to obtain a plurality of compressed segments. When partial data needs to be decompressed, a compressed segment in which the partial data that needs to be decompressed is in may be decompressed.

However, because repeated information in the data may be in different parts, if the related technology 2 is used for data compression, the repeated information in the different parts cannot be identified and removed. Consequently, an overall compression ratio of the data is reduced. For example, when a size of data that needs to be compressed is small, for example, the data that needs to be compressed is data in a page of a database, and a length of the data in the page is usually 8 kilobytes (kilobytes, KB) to 16 KB, a repetition rate of the data with the small size may be low. If the data is divided into a plurality of independent parts, an information repetition rate in each independent part may be lower, or even information in each independent part is not repeated, leading to a low compression ratio.

In addition, in the related technology 2, a compression algorithm needs to be invoked a plurality of times to separately compress a plurality of parts of data in an independent compression process. In other words, each time an independent part is compressed, the compression algorithm needs to be invoked. When the compression algorithm is invoked, an index structure for compression may need to be introduced, and independent index structures need to be maintained for different parts to identify repeated information in the different parts. If the compression algorithm is invoked and enabled a plurality of times, the index structure is initialized. As a result, costs of invoking the compression algorithm are high, causing a waste of resources.

This application provides a data processing method, to compress and decompress data, and support decompression of partial data. The method has a stable compression ratio, strong scenario adaptability, and low costs of invoking a compression algorithm, so that a waste of resources can be avoided. The data processing method can be implemented based on a general compression algorithm, for example, implemented based on the LZ77 algorithm.

To make the descriptions of the data processing method provided in embodiments of this application easier to understand, before the data processing method provided in embodiments of this application is described, a process of performing general data compression and decompression based on the LZ77 algorithm is first described as an example.

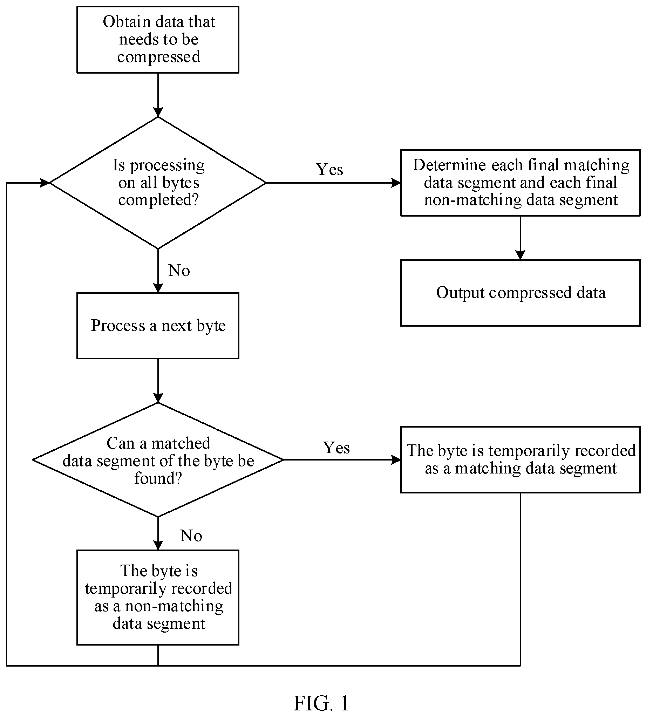

For example, FIG. 1 is a schematic flowchart of performing general data compression based on an LZ77 algorithm according to a related technology. First, data that needs to be compressed is obtained, the data that needs to be compressed is considered as a byte stream including a plurality of bytes, and the plurality of bytes are processed in sequence. Before each byte is processed, it is determined whether processing on all bytes in the byte stream is completed. If there is still a byte that has not been processed, the next byte continues to be processed.

An example in which processing is performed on a byte x is used. First, a matched data segment of the byte x needs to be searched for. For example, a byte that is the same as the byte x may be searched for in bytes before the byte x. If there is a byte that is the same as the byte x in the bytes before the byte x, the byte x is temporarily recorded as a matching data segment, and the byte that is the same as the byte x and that is before the byte x is temporarily recorded as the matched data segment. If there is no byte that is the same as the byte x, the byte x is temporarily recorded as a non-matching data segment. The matched data segment may also be referred to as a matched string, the matching data segment may also be referred to as a matching string, and the non-matching data segment may also be referred to as a non-matching string.

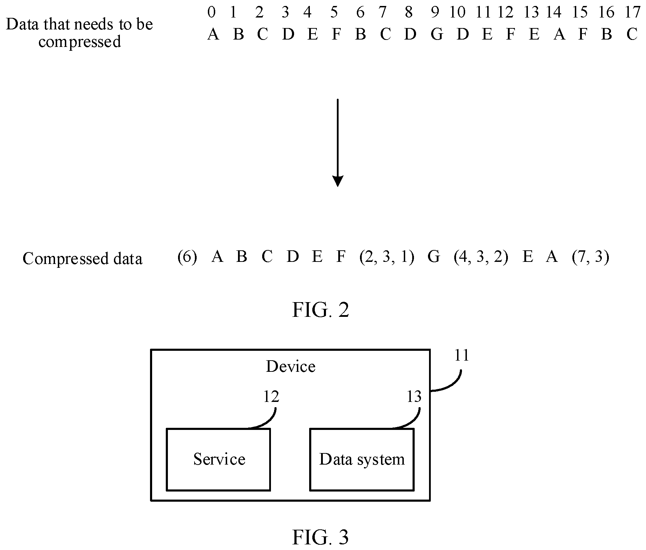

For example, FIG. 2 is a schematic flowchart of performing general data compression based on an LZ77 algorithm according to a related technology. Obtained data that needs to be compressed is ABCDEFBCDGDEFEAFBC, and each letter is a byte. Therefore, the data that needs to be compressed may be considered as a byte stream including 18 bytes. Because the data that needs to be compressed is in a text form, the data that needs to be compressed may also be referred to as a text or an original text (original text) that needs to be compressed.

After compression starts, the bytes in the byte stream are processed in sequence. When the 1^{st} byte A is processed, a matched data segment of the 1^{st} byte A is first searched for. Because the 1^{st} byte A is the 1^{st} byte in the byte stream, and there is no byte that is the same as the 1^{st} byte A and that is before the 1^{st} byte A, in other words, the matched data segment corresponding to the 1^{st} byte A cannot be found in the byte stream, the 1^{st} byte A may be temporarily recorded as a non-matching data segment. Matched data segments corresponding to the 2^{nd} byte B, the 3^{rd} byte C, the 4^{th} byte D, the 5^{th} byte E, and the 6^{th} byte F cannot be found in the byte stream. Therefore, the 2^{nd} byte B, the 3^{rd} byte C, the 4^{th} byte D, the 5^{th} byte E, and the 6^{th} byte F may all be temporarily recorded as non-matching data segments. When the 7^{th} byte B is processed, it is found that the 2^{nd} byte B is the same as the 7^{th} byte B, and the 2^{nd} byte B is before the 7^{th} byte B. Therefore, the 7^{th} byte B may be temporarily recorded as a matching data segment, and the 2^{nd} byte B may be temporarily recorded as a matched data segment of the 7^{th} byte B. When the 8^{th} byte C and the 9^{th} byte D are processed, it is found that the 3^{rd} byte C is the same as the 8^{th} byte C, and the 4^{th} byte D is the same as the 9^{th} byte D. Therefore, the 8^{th} byte C and the 9^{th} byte D may be temporarily recorded as matching data segments, the 3^{rd} byte C is temporarily recorded as a matched data segment of the 8^{th} byte C, and the 4^{th} byte D is temporarily recorded as a matched data segment of the 9^{th} byte D.

In a process of processing the bytes in the byte stream in sequence, if a plurality of consecutive bytes are the same as a plurality of previous consecutive bytes, the plurality of consecutive bytes may be combined into one matching data segment, and the plurality of previous consecutive bytes are determined as a matched data segment of the matching data segment. One or more consecutive bytes that are between two adjacent matching data segments and that are temporarily recoded as a non-matching data segment may be combined into one non-matching data segment.

For example, still refer to FIG. 2. When the 10^{th} byte G is processed, a byte that is the same as the 10^{th} byte G cannot be found in the byte stream, and the 10^{th} byte G may be temporarily recorded as a non-matching data segment. The 7^{th} byte B, the 8^{th} byte C, and the 9^{th} byte D that are consecutive are the same as the 2^{nd} byte B, the 3^{rd} byte C, and the 4^{th} byte D that are consecutive, but the 10^{th} byte G is different from the 5^{th} byte F. Therefore, the 7^{th} byte B, the 8^{th} byte C, and the 9^{th} byte D that are consecutive may be combined into a matching data segment BCD, and the 2^{nd} byte B, the 3^{rd} byte C, and the 4^{th} byte D that are consecutive are determined as a matched data segment BCD of the matching data segment.

In addition, because the 1^{st} byte A to the 6^{th} byte F are all temporarily recorded as non-matching data segments, and it is determined that the 7^{th} byte B after the 6^{th} byte F belongs to the matching data segment, the 1^{st} byte A to the 6^{th} byte F may be combined into a non-matching data segment ABCDEF. For a process of processing other bytes in the byte stream in FIG. 2, refer to the foregoing descriptions. Details are not described herein again.

In some cases, after recording and combination of each matching data segment and each non-matching data segment are completed, a final matching data segment and a final non-matching data segment may be determined based on a length of each combined matching data segment. If the length of the matching data segment obtained through combination is less than a length threshold, the matching data segment may be re-determined as a non-matching data segment.

For example, in FIG. 2, the 14^{th} byte E is the same as the 12^{th} byte E and the 5^{th} byte E, and the 14^{th} byte E is recorded as a matching data segment E, but a length of the matching data segment E is 1 bit (bit, B), which is less than the length threshold 3B. Therefore, the matching data segment E may be re-determined as a non-matching data segment E. The 15^{th} byte A is the same as the 1^{st} byte A, and the 15^{th} byte A is recorded as a matching data segment A. However, a length of the matching data segment A is 1B, which is less than the length threshold 3B. Therefore, the matching data segment A may be re-determined as a non-matching data segment A. Because the previous byte F of the 14^{th} byte E belongs to a matching data segment DEF whose length is equal to the length threshold, and the next byte F of the 15^{th} byte A also belongs to a matching data segment FBC whose length is equal to the length threshold, the 14^{th} byte E and the 15^{th} byte A may be combined into a non-matching data segment EA.

After each final matching data segment and each final non-matching data segment are determined, data compression may be performed for features of each matching data segment and each non-matching data segment, and compressed data is output; for the non-matching data segment, the non-matching data segment and a length of the non-matching data segment are output; and for the matching data segment, a length of the matching data segment and matching offset of the matching data segment are output. The matching offset of the matching data segment means a distance between the matching data segment and a matched data segment of the matching data segment, for example, may be a byte length between a 1^{st} byte in the matching data segment and a last byte in the matched data segment.

The byte stream in FIG. 2 is still used as an example. The 1^{st} byte A to the 6^{th} byte F are finally determined as the non-matching data segment ABCDEF whose length is 6B, and therefore, the length of 6B and the non-matching data segment ABCDEF may be output. The 7^{th} byte B to the 9^{th} byte D are finally determined as the matching data segment BCD whose length is 3B, the matched data segment BCD of the matching data segment BCD is the 2^{nd} byte B to the 4^{th} byte D, a distance between the matching data segment BCD and the matched data segment BCD is 2B, that is, matching offset of the matching data segment BCD is 2B, and therefore, the length of 3B and the matching offset of 2B (where the unit B of the length and the offset may be ignored) may be output. The 10^{th} byte G is finally determined as a non-matching data segment G whose length is 1B, and therefore, the length of 1B and the non-matching data segment G may be output. The 11^{th} byte D to the 13^{th} byte F are finally determined as the matching data segment DEF whose length is 3B, a matched data segment DEF of the matching data segment DEF is the 4^{th} byte D to the 6^{th} byte F, a distance between the matching data segment DEF and the matched data segment DEF is 4B, that is, matching offset of the matching data segment DEF is 4B, and therefore, the length of 3B and the matching offset of 4B may be output. The 14^{th} byte E and the 15^{th} byte A are finally determined as the non-matching data segment EA whose length is 2B, and therefore, the length of 2B and the non-matching data segment EA may be output. The 16^{th} byte F to the 18^{th} byte C are finally determined as the matching data segment FBC whose length is 3B, a matched data segment FBC of the matching data segment FBC is the 6^{th} byte F to the 8^{th} byte C, and a distance between the matching data segment FBC and the matched data segment FBC is 7B, that is, matching offset of the matching data segment is 7B, and therefore, the length of 3B and the matching offset of 7B may be output.

In a process of compressing the matching data segment, the compression needs to be performed based on a location of the matched data segment and a distance between the matching data segment and the matched data segment. Therefore, in some cases, it may be considered that compression of the matching data segment is completed by referencing the matched data segment. Correspondingly, in a process of compressing the non-matching data segment, a value of the non-matching data segment and a length of the non-matching data segment need to be used, and therefore, it may also be considered that compression of the non-matching data segment is completed by referencing the non-matching data segment.

After outputs for each matched data segment and each non-matching data segment are determined, output results may be sorted to obtain compressed data. The compressed data is also in a text form. Therefore, the compressed data may also be referred to as a compressed text (compressed text). Still refer to FIG. 2. The compressed data obtained through compression according to the foregoing compression method in FIG. 2 is (6) ABCDEF (2, 3, 1) G (4, 3, 2) EA (7, 3). 6 is the length of 6B of the non-matching data segment ABCDEF. 2, 3, and 1 respectively represent the matching offset of 2B of the matching data segment BCD, the length of 3B of the matching data segment BCD, and the length of 1B of the next non-matching data segment G adjacent to the matching data segment BCD. 4, 3, and 2 respectively represent the matching offset of 4B of the matching data segment DEF, the length of 3B of the matching data segment DEF, and the length of 2B of the next non-matching data segment EA adjacent to the matching data segment DEF. 7 and 3 respectively represent the matching offset of 7B of the matching data segment FBC and the length of 3B of the matching data segment FBC. Because there is no non-matching data segment after the matching data segment FBC, a length of a non-matching data segment after the matching data segment FBC may be omitted.

After data compression is completed according to the foregoing compression method, a data system stores the compressed data, and does not store the data before compression, to reduce space needed for storing data and save storage costs. Then, if stored data needs to be invoked, the stored data may be first decompressed to obtain decompressed data for data computing. If the data that needs to be invoked is partial data in the compressed data, partial decompression needs to be performed on the partial data to restore the partial data before the compression.

For example, still refer to FIG. 2. The data system stores the compressed data (6) ABCDEF (2, 3, 1) G (4, 3, 2) EA (7, 3). If the partial data that needs to be invoked is DEFEAFBC in the original data, an invoker sends, to a data management system, a start location of the partial data in the complete data before compression and a length of the partial data. Optionally, the start location of the partial data in the complete data before compression may be a location, in the complete data before compression, of a 1^{st} byte in the partial data. A location of each byte in the complete data before compression may be a quantity of bytes (for example, a number marked above the data before compression in FIG. 2) between each byte and a 1^{st} byte in the complete data before compression. For example, the 1^{st} byte D in the partial data DEFEAFBC is the 11^{th} byte in the complete data before compression, and therefore, the start location of the partial data DEFEAFBC in the complete data before compression is 10. The length of the partial data may be a length of bytes of the partial data. For example, if a quantity of bytes of the partial data DEFEAFBC is 8, and a length of each byte is 1B, the length of the partial data DEFEAFBC is 8B.

After receiving the start location of the partial data in the complete data before compression and the length of the partial data, the data management system determines, from the compressed data, partial compressed data corresponding to the partial data, and decompresses the partial compressed data, to obtain the partial data before compression. The data management system may determine, based on a length and an order of each data segment included in each compressed segment in the compressed data and the start location and the length of the partial data, the partial compressed data corresponding to the partial data.

For example, based on the foregoing example, in the compressed data, a 1^{st} compressed segment (6) ABCDEF includes a 1^{st} data segment ABCDEF with a length of 6B, a 2^{nd} compressed segment (2, 3, 1) includes a 2^{nd} data segment BCD with a length of 3B and a 3^{rd} data segment G with a length of 1B, a 4^{th} compressed segment (4, 3, 2) includes a 4^{th} data segment DEF with a length of 3B and a 5^{th} data segment EA with a length of 2B, and a 6^{th} compressed segment (7, 3) includes a 6^{th} data segment FBC with a length of 3B.

If the start location of the partial data DEFEAFBC that needs to be invoked and that is in the complete data before compression is 10, the compressed segment (4, 3, 2) corresponding to the data segment DEF to which the 11^{th} byte D belongs needs to be found. The length of the 1^{st} data segment ABCDEF is 6B, and therefore, the 11^{th} byte D does not belong to the 1^{st} data segment ABCDEF. An accumulated length of the 1^{st} data segment ABCDEF and the 2^{nd} data segment BCD is 9B, and therefore, the 11^{th} byte D does not belong to the 2^{nd} data segment BCD. An accumulated length of the 1^{st} data segment ABCDEF to the 3^{rd} data segment G is 10B, and therefore, the 11^{th} byte D does not belong to the 3^{rd} data segment G. However, it may be determined that the 11^{th} byte D belongs to a next data segment of the 3^{rd} data segment G, that is, the 4^{th} data segment DEF. Therefore, it may be determined that decompression needs to start from the 4^{th} compressed segment (4, 3, 2) corresponding to the 4^{th} data segment DEF.

After a compressed segment to which the start location of the partial compressed data that needs to be decompressed belongs is determined, a compressed segment to which an end location of the partial compressed data that needs to be decompressed belongs may be determined based on the start location and the length of the partial data. For example, if the start location of the partial data DEFEAFBC that needs to be invoked and that is in the entire original data is 10, and the length of the partial data that needs to be invoked is 8B, it may be determined that an end location of the partial data DEFEAFBC that needs to be invoked and that is in the complete data before compression is 17. An accumulated length of the 1^{st} data segment ABCDEF to the 6^{th} data segment FBC in the complete data before compression is 18B. Therefore, it may be determined that a compressed segment to which an end location of the partial data DEFEAFBC that needs to be invoked belongs is the 6^{th} compressed segment (7, 3) corresponding to the 6^{th} data segment FBC, and compressed segments that need to be decompressed are the 4^{th} compressed segment (4, 3, 2) to the 6^{th} compressed segment (7, 3).

After the compressed segments that need to be decompressed are determined, the compressed segments that need to be decompressed may be sequentially decompressed. A compressed segment obtained by compressing a non-matching data segment may be decompressed based on a length of the compressed segment and a value of the compressed segment, to obtain a value of a data segment before the compressed segment is compressed. A compressed segment obtained by compressing a matching data segment may be decompressed based on a length of the matching data segment in the compressed segment, a distance between the matching data segment and a referenced matched data segment, and a value of the matched data segment, to obtain a value of a data segment before the compressed segment is compressed.

The foregoing example is still used. The determined compressed segments that need to be decompressed are the 4^{th} compressed segment (4, 3, 2) to the 6^{th} compressed segment (7, 3). The 4^{th} compressed segment (4, 3, 2) may be decompressed first. It can be learned from a format of values of the 4^{th} compressed segment (4, 3, 2) that the 4^{th} data segment of the 4^{th} compressed segment obtained through compression is a matching data segment. Therefore, it may be determined, based on the values of the 4^{th} compressed segment (4, 3, 2), that a distance between the 4^{th} data segment DEF and a matched data segment referenced when the 4^{th} compressed segment (4, 3, 2) is obtained through compression is 4B, and then a compressed segment corresponding to a data segment whose distance to the 4^{th} data segment DEF is 4B may be determined in compressed data before the 4^{th} compressed segment (4, 3, 2).

It can be learned by reading values of the 2^{nd} compressed segment (2, 3, 1) that the length of the 3^{rd} data segment G corresponding to a 3^{rd} compressed segment G is 1B, the length of the 2^{nd} data segment BCD corresponding to the 2^{nd} compressed segment (2, 3, 1) is 3B, and a sum of the lengths of the 2^{nd} data segment BCD and the 3^{rd} data segment G is 4B. This indicates that a matched data segment referenced by the 4^{th} data segment DEF is a data segment before the 2^{nd} data segment BCD, that is, the 1^{st} data segment ABCDEF. In addition, reference is performed by the 4^{th} data segment BCD starting from the last byte F in the 1^{st} data segment ABCDEF, and three bytes are referenced forward in total. Because the 1^{st} data segment ABCDEF of the 1^{st} compressed segment (6) ABCDEF obtained through compression is a non-matching data segment, the last byte F, the 2^{nd} to last byte E, and the last 3^{rd} byte D of the 1^{st} compressed segment (6) ABCDEF can be directly read, and the data segment DEF is output, to complete decompression and restoration of the 4^{th} compressed segment DEF.

Because a data segment of a 5^{th} compressed segment EA obtained through compression is a non-matching data segment, a value of the 5^{th} compressed segment EA may be directly read, and the data segment EA is output, to complete decompression and restoration of the 5^{th} data segment EA. It can be learned from a format of values of the 6^{th} compressed segment (7, 3) that the 6^{th} data segment FBC of the 6^{th} compressed segment (7, 3) obtained through compression is a matching data segment. Therefore, it may be determined, based on the values of the 6^{th} compressed segment (7, 3), that a distance between the 6^{th} data segment FBC and a matched data segment referenced when the 6^{th} compressed segment (7, 3) is obtained through compression is 7B, and a data segment whose distance to the 6^{th} data segment FBC is 7B may be determined in compressed data before the 6^{th} compressed segment (7, 3).

It can be learned by reading the values of the 2^{nd} compressed segment (2, 3, 1) and the 4^{th} compressed segment (4, 3, 2) that the length of the 4^{th} data segment DEF corresponding to the 4^{th} compressed segment (4, 3, 2) is 3B, the length of the 5^{th} data segment EA corresponding to the 5^{th} compressed segment EA is 2B, the length of the 3^{rd} data segment G corresponding to the 3^{rd} compressed segment G is 1B, and a sum of the lengths of the 5^{th} data segment EA to the 3^{rd} data segment G is 6B. This indicates that a matched data segment referenced by the 6^{th} data segment FBC is a data segment before the 3^{rd} data segment G, that is, the 2^{nd} data segment BCD. In addition, reference is performed by the 6^{th} data segment FBC starting from the 2^{nd} to last byte C of the 2^{nd} data segment BCD, and three bytes are referenced forward in total. Because the 2^{nd} data segment BCD of the 2^{nd} compressed segment (2, 3, 1) obtained through compression is a matching data segment, the 2^{nd} compressed segment (2, 3, 1) needs to be first decompressed and restored to the 2^{nd} data segment BCD, and then the 6^{th} compressed segment (7, 3) is decompressed based on the 2^{nd} data segment BCD.

In other words, the matched data segment directly referenced in a process of compressing the 6^{th} data segment FBC includes the bytes in the 2^{nd} data segment BCD, and the 1^{st} data segment ABCDEF is directly referenced in a process of compressing the 2^{nd} data segment BCD. As a result, for the 6^{th} data segment FBC, the 1^{st} data segment ABCDEF is indirectly referenced, and two-layer decompression is needed in the process of decompressing the 6^{th} compressed segment (7, 3).

It can be learned with reference to the foregoing examples that, when partial decompression is performed on the compressed data obtained through compression according to the general LZ77-based data compression method, there may be a case in which two-layer decompression or even multi-layer decompression is needed, and the case in which two-layer decompression or multi-layer decompression is needed cannot be predicted before decompression, in other words, before decompression is completed, a quantity, sizes, and locations of compressed segments or data segments that actually participate in decompression cannot be determined, and decompression efficiency is in positive correlation with a quantity and sizes of compressed segments that need to be decompressed. Consequently, in a case in which the quantity and the sizes of the compressed segments or data segments that actually participate in decompression are not determined, it is difficult to ensure decompression efficiency. In a scenario in which partial decompression needs to be performed frequently, there is no stable decompression boundary and decompression efficiency, resulting in unstable decompression performance. The decompression performance may be determined based on decompression efficiency and decompression accuracy. If decompression performance varies for different data, a running status of a service for which data query needs to be performed may be affected, and user experience cannot be ensured.

The data processing method provided in embodiments of this application can ensure that a decompression boundary is determined before data decompression, and decompression performance is stable. For example, FIG. 3 shows an implementation scenario of the method. The implementation scenario includes a device 11 configured to provide a cloud computing service. Optionally, the device 11 may be deployed on a cloud. For example, the device 11 may be a data management device on the cloud or another device that needs to perform data processing and that is on the cloud. Different services 12 and different data systems 13 may be deployed in the device 11, and the device 11 may store and process data by using the data system 13. The data system 13 may also be referred to as a data management system. The data system 13 may be a system configured to manage data, like a database. A HOT-based data processing environment and an LSM-tree-based data processing environment may be installed in the data system 13.

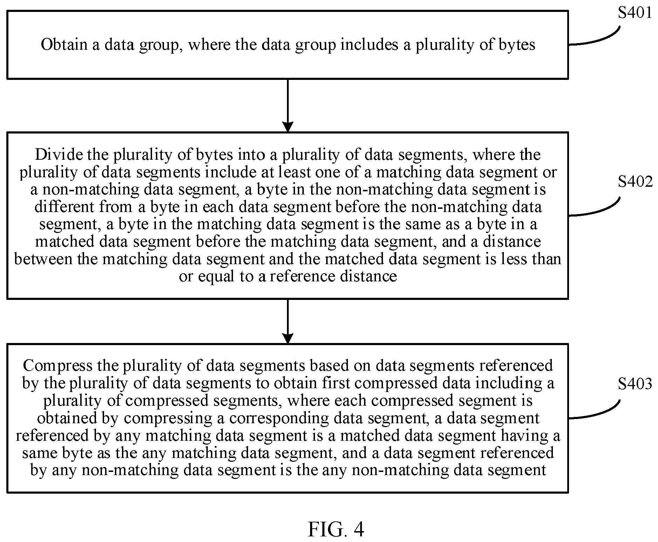

The data processing method provided in embodiments of this application includes a data compression method and a data decompression method. The data compression method can provide a basis for stable data decompression performance. The following first describes the data compression method provided in embodiments of this application. For example, FIG. 4 is a schematic flowchart of a data compression method. The data compression method includes but is not limited to the following S401 to S403.

S401: Obtain a data group, where the data group includes a plurality of bytes.

The data group is a data compression unit. One data group may include one or more groups of data, one group of data may include one or more pieces of data, and one piece of data may include one or more bytes. Therefore, one data group may include one or more bytes. If one data group includes one byte, the data group does not need to be compressed. However, this embodiment of this application is intended to compress or decompress the data group. Therefore, in this embodiment of this application, a case in which the data group includes only one byte is not discussed temporarily in the data processing method, but a case in which the data group includes a plurality of bytes is used as an example to describe the data processing method and process.

A size of the data group is not limited in this embodiment of this application, and sizes of the data group in different data processing environments may be the same or may be different. A HOT-based data processing environment and an LSM-tree-based data processing environment are used as examples below in this embodiment of this application to describe composition and a determining process of a data group.

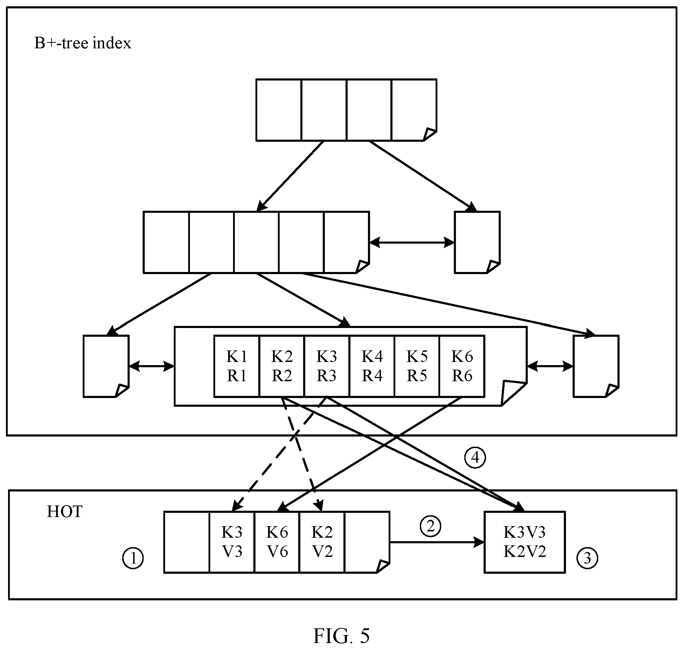

For example, FIG. 5 is a diagram of a HOT-based data processing environment. In the HOT-based data processing environment, data is stored in an independent heap located in a HOT, and the heap is a logical collection of a plurality of pieces of data. Each piece of data stored in the heap corresponds to an address for obtaining the data and a key (Key, K) value for data query. The address for obtaining the data may be represented by a row identifier (row identifier, RID). Based on the HOT, a binary (binary, B)+-tree (Tree) index may be established based on the key of each data. A bottom-layer node of the index includes a plurality of 2-tuples, one 2-tuple includes a key and an RID of one piece of data, and each 2-tuple may be represented as <Key, RID> or <K, R>. In a B+-tree, the 2-tuples are sorted in a sequence of included keys. For example, the bottom-layer node of a B+-tree in FIG. 5 includes six 2-tuples in total, which are respectively <K1, R1>, <K2, R2>, <K3, R3>, <K4, R4>, <K5, R5>, and <K6, R6>. The six 2-tuples are arranged in ascending order of K.

A physical structure of the HOT includes a plurality of storage blocks (Blocks), each storage block stores a plurality of pieces of data, and a size of each storage block may be, for example, 8 KB to 16 KB. Because values (values, V) of different pieces of data are different, the different pieces of data may alternatively be represented by using different values, to distinguish between the different pieces of data by using different values. An arrangement sequence of the plurality of pieces of data in each storage block is irrelevant to K corresponding to the plurality of pieces of data. For example, a storage block indicated by ① in FIG. 5 includes data 2 represented by V2, data 3 represented by V3, and data 6 represented by V6. The data 2 corresponds to K2, the data 3 corresponds to K3, and the data 6 corresponds to K6. The three pieces of data are arranged in the following sequence: the data 3, the data 6, and the data 2, not arranged according to an order of K of each piece of data.

In the HOT-based data processing environment, a plurality of pieces of data that meets a compression condition in a storage block may be compressed, and the plurality of pieces of data that meets the compression condition may be all data stored in the storage block, or may be partial data stored in the storage block. The compression condition may be set based on experience, or may be specified by a user. For example, the compression condition may be a length threshold of data. If a length of the data is greater than or equal to the length threshold, the data may be determined as data that meets the compression condition. Otherwise, if the length of the data is less than the length threshold, the data may be determined as data that does not meet the compression condition.

A plurality of pieces of data for compression in one storage block may be referred to as a data group. In other words, in this embodiment of this application, when the data group is stored in the HOT, the data group may include the plurality of pieces of data in the storage block of the HOT. For example, in a compression process indicated by ② in FIG. 5, if it is determined that the data 2 represented by V2 and the data 3 represented by V3 are data that meets the compression condition, the data 2 and the data 3 may be used as one data group, that is, the data group includes the data 2 and the data 3 in the storage block.

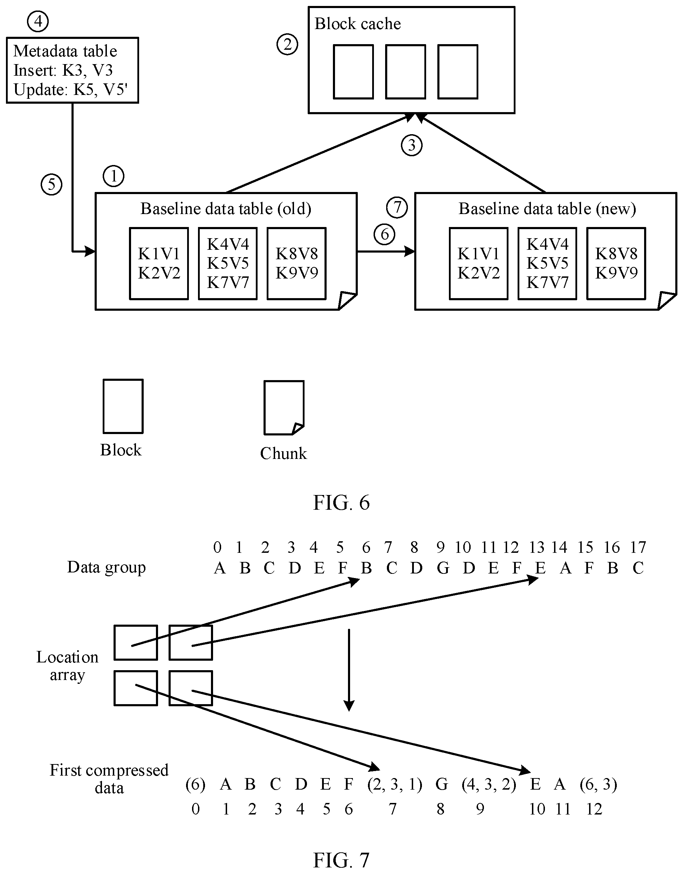

For example, FIG. 6 is a diagram of an LSM-tree-based data processing environment. In an LSM-tree-based storage engine, stored data includes baseline data and incremental data. The baseline data may be original data uploaded by a user, and the baseline data is stored in a sorted string table (sorted string table, SSTable). The SSTable is shown in ① in FIG. 6.

In a physical structure, a minimum unit corresponding to one SSTable is a chunk (Chunk). The chunk may also be referred to as a baseline database, and a size of the baseline database may be 64 KB to 2 MB. One baseline database includes a plurality of storage blocks, and one or more pieces of baseline data are persistently stored in each storage block. The storage blocks may have different sizes. The size of the storage block may be any size within a reference range. The reference range may be determined based on experience or specified by a user. For example, the reference range may be 8 KB to 16 KB. Logically, the baseline data is sorted in an order of K corresponding to each piece of baseline data. K is a value for locating each piece of baseline data, and is similar to K in FIG. 5. K corresponding to each piece of baseline data is maintained in independent metadata. Therefore, distribution of a value range of K of each storage block may be recorded by using the metadata. In addition, the baseline data may be represented by different values (V). For example, a storage block in the SSTable shown in ① in FIG. 6 stores baseline data 1 represented by V1 and baseline data 2 represented by V2. The baseline data 1 corresponds to K1, the baseline data 2 corresponds to K2, and the baseline data 1 and the baseline data 2 are arranged in ascending order of respective K1 and K2.

Another type of data stored in the LSM-tree-based storage engine, that is, incremental data, is for recording update (update) or modification of the baseline data. The modification of the baseline data includes but is not limited to insertion (insert) or deletion (delete). As shown in ④ in FIG. 6, the incremental data is stored in a memory table (MemTable). Optionally, the memory table may also be referred to as a metadata table. One piece of incremental data in the memory table records update or modification of one piece of baseline data. For example, a 1^{st} piece of incremental data in the memory table in FIG. 6 records inserted baseline data 3 represented by V3, and the baseline data 3 corresponds to K3; and a 2^{nd} piece of incremental data records that a value of baseline data 5 corresponding to V5 is updated to V5'.

The update or modification of the baseline data does not directly affect the baseline data. Therefore, when the baseline data is queried based on a service requirement, data that is in the incremental data and the baseline data and that is needed by a service needs to be combined to obtain combined baseline data, and then the combined baseline data is returned. For example, when the baseline data 5 is queried based on the service requirement, it is determined that incremental data corresponding to the baseline data 5 is updating the value of the baseline data 5 from V5 to V5'. Therefore, the baseline data 5 and the incremental data corresponding to the baseline data 5 may be combined, in other words, the value of the baseline data 5 is updated from V5 to V5', to obtain combined baseline data 5, and the combined baseline data 5 is returned.

Because the MemTable has a limited size, when the MemTable increases to a specific size, automatic combination of the incremental data and the baseline data is triggered (a process indicated by ⑤ in FIG. 6), to generate new baseline data (a process indicated by ⑥ in FIG. 6). The new baseline data does not directly cover the old baseline data, but is stored in a new (new) SSTable shown in ⑦ in FIG. 6. The new SSTable is located in newly allocated storage space, and the new baseline data is persistently stored in the new SSTable. The baseline data before combination is the old (old) baseline data. The SSTable that stores the old baseline data is the old SSTable.

The old baseline data expires when meeting an expiration condition, and storage space occupied by the old SSTable is released. The expiration condition may include a time threshold of time after generation of the new baseline data. If the time after the generation of the new baseline data reaches the time threshold, the old baseline data may be deleted, and the storage space occupied by the old SSTable is released.

In this embodiment of this application, data may be compressed in a process of generating the new baseline data by combining the old baseline data and the incremental data. In some cases, the baseline database is a minimum unit of data writing and space allocation in an input/output (input/output, I/O) process. Therefore, in a compression process, all baseline data in one baseline database may be compressed as one data group, or a plurality of consecutive modified storage blocks in one baseline database may be compressed as one data group. In other words, in a case in which the data group is stored in the baseline database of the LSM-tree, the data group includes data in a plurality of storage blocks in the baseline database.

Regardless of a data processing environment or a type of data included in a data group, the data group may include a plurality of bytes, and the data group including the plurality of bytes may be compressed. For a process of compressing the data group including the plurality of bytes, refer to the following S402 and S403. Details are not described herein.

S402: Divide the plurality of bytes into a plurality of data segments, where the plurality of data segments include at least one of a matching data segment or a non-matching data segment, a byte in the non-matching data segment is different from a byte in each data segment before the non-matching data segment, a byte in the matching data segment is the same as a byte in a matched data segment before the matching data segment, and a distance between the matching data segment and the matched data segment is less than or equal to a reference distance.

For descriptions of the matching data segment, the non-matching data segment, and the matched data segment, refer to the foregoing descriptions of the LZ77-based general compression algorithm. Details are not described herein again. In a process of obtaining the plurality of data segments through division in this embodiment of this application, a distance between the matching data segment and the matched data segment needs to be restricted, so that a distance between a final matching data segment obtained through division and the matched data segment is less than or equal to the reference distance. A value of the reference distance may be set based on experience, or may be predefined based on a user requirement.

A method for restricting the distance between the matching data segment and the matched data segment is not limited in this embodiment of this application. For example, the distance between the matching data segment and the matched data segment is restricted by using a location array. A process of dividing the plurality of bytes into the plurality of data segments may include: dividing the plurality of bytes into a plurality of candidate data segments; obtaining a location array of a candidate matching data segment; and in a case in which there is a candidate distance less than or equal to the reference distance in at least one candidate distance, determining the candidate matching data segment as the matching data segment; or in a case in which at least one candidate distance is greater than the reference distance, determining the candidate matching data segment as the non-matching data segment. The plurality of candidate data segments include at least one of the candidate matching data segment or the non-matching data segment, and a byte in the candidate matching data segment is the same as a byte in at least one candidate matched data segment before the candidate matching data segment. A process of dividing the plurality of bytes into the plurality of candidate data segments is the same as the foregoing process of dividing the plurality of bytes into the plurality of data segments by using the LZ77-based general compression algorithm. Details are not described herein again.

The location array for restricting the distance between the matching data segment and the matched data segment may be generated in the process of obtaining the plurality of candidate data segments through division. The location array may include a location of the candidate matching data segment and a location of the at least one candidate matched data segment corresponding to the candidate matching data segment. The location of the candidate matching data segment includes a location of each byte in the candidate matching data segment, and the location of the at least one candidate matched data segment includes a location of each byte in the at least one candidate matched data segment. In this embodiment of this application, the location of each byte may be represented by using an offset location of each byte in a byte stream, or may be represented by an order of each byte in the byte stream.

An embodiment of this application provides a symbol system applied to a data processing method. The symbol system includes a method for representing each byte, a method for representing each data segment, and a method for representing a location array. The following describes composition and functions of a location array by describing the symbol system. In the symbol system, a to-be-compressed data group is considered as a byte stream whose length is n, and the byte stream is set to S. S[i] represents an i^{th} byte in S, and S[i..j] represents a data segment starting from the i^{th} byte to a (j-1)^{th} byte in S, that is, a substring from the i^{th} byte to the (j-1)^{th} byte. S[i..j] may alternatively be represented in a form like S[i, j] or S[i-j]. Correspondingly, in the symbol system, a compressed first compressed data is considered as a byte stream whose length is m, and a compressed byte stream is set to D. A method for representing each compressed segment in D is the same as the method for representing each data segment in S. Details are not described herein again.

A length of the location array is n. Each byte in the byte stream corresponds to at least one ancestor (Ancestor) location. The ancestor location of each byte is a location of a byte referenced by each byte. The location array records a correspondence between a location of each byte and the ancestor location of each byte. Therefore, location data may also be referred to as an ancestor array.

An ancestor location of a byte in the non-matching data segment is a location of the byte. For example, an ancestor location of a 1^{st} byte in the non-matching data segment is a location of the 1^{st} byte. In the symbol system provided in this embodiment of this application, for a non-matching data segment S[i..i+l], Ancestor[i+k]=i+k is set in the location array, where k is greater than or equal to 0 and is less than l, and l is a length (length, l) of the candidate matching data segment and a length (length, l) of the candidate matched data segment.

An ancestor location of a byte in the candidate matching data segment is an ancestor location of a corresponding byte in the candidate matched data segment corresponding to the candidate matching data segment. If the candidate matched data segment belongs to the non-matching data segment, that is, another data segment is not referenced by the candidate matched data segment, the ancestor location of the byte in the candidate matching data segment is the location of the corresponding byte in the candidate matched data segment corresponding to the candidate matching data segment. If the candidate matched data segment belongs to the matching data segment, that is, another candidate matched data segment is referenced by the candidate matched data segment, the ancestor location of the byte in the candidate matching data segment may include at least one of the location of the corresponding byte in the candidate matched data segment or a location of a corresponding byte in the another candidate matched data segment.

For example, if a candidate matched data segment referenced by a candidate matching data segment 1 is a candidate matched data segment 2, the candidate matched data segment 2 belongs to a non-matching data segment, and a byte referenced by a 1^{st} byte in the candidate matching data segment 1 is a 1^{st} byte in the candidate matched data segment 2, an ancestor location of the 1^{st} byte in the candidate matching data segment 1 is a location of the 1^{st} byte in the candidate matched data segment 2 in a byte stream. For another example, if a candidate matched data segment 2 belongs to a candidate matching data segment 4, a candidate matched data segment 5 is referenced by the candidate matching data segment 4, and the candidate matched data segment 5 belongs to a non-matching data segment 6, the candidate matched data segment 2 is directly referenced by a candidate matching data segment 1, and the candidate matched data segment 5 is indirectly referenced by the candidate matching data segment 1. The byte directly referenced by the 1^{st} byte in the candidate matching data segment 1 is the 1^{st} byte in the candidate matched data segment 2, and a byte indirectly referenced by the 1^{st} byte in the candidate matching data segment 1 is a 1^{st} byte in the candidate matched data segment 5. In this case, the ancestor location of the 1^{st} byte in the candidate matching data segment 1 may include at least one of the location of the 1^{st} byte in the candidate matched data segment 2 or a location of the 1^{st} byte in the candidate matched data segment 5. In a possible implementation, if the candidate matching data segment is the same as a plurality of candidate matched data segments, a candidate matched data segment directly referenced by the candidate matching data segment may be a candidate matched data segment closest to the candidate matching data segment.

In the symbol system provided in this embodiment of this application, for a candidate matching data segment S[i..i+l], a candidate matched data segment directly referenced by the candidate matching data segment S[i..i+l] is set to S[j..j+l], where j is less than i, that is, j is a byte before i. In the location array, Ancestor[i+k]=Ancestor[j+k] and Ancestor[i+k]=j+k are set, where k is greater than or equal to 0 and less than l. To be specific, an ancestor location of S[i+k] in the byte stream includes at least one of an ancestor location of S[j+k] or a location of S[j+k].

In some cases, because the location of the candidate matched data segment corresponding to the candidate matching data segment may be referred to as a left boundary for decompressing the candidate matching data segment, the location array may also be referred to as a left boundary array. In this case, Ancestor[i] indicates a left boundary for decompressing S[i], to be specific, decompression starts from an Ancestor[i]^{th} character in S, and S[i] can be decompressed.

After the location array is generated, a distance between the location of each byte and the ancestor location corresponding to each byte may be determined based in the location of each byte and the ancestor location corresponding to each byte in the location array, to determine at least one candidate distance corresponding to each candidate matching data segment. For any candidate matching data segment, the at least one candidate distance is determined based on a location of the candidate matching data segment and a location of at least one candidate matched data segment.

In a possible implementation, at least one candidate distance between each candidate matching data segment and the at least one candidate matched data segment referenced by each candidate matching data segment may be determined based on a location of a 1^{st} byte in each candidate matching data segment and an ancestor location corresponding to the 1^{st} byte. For example, a candidate matched data segment directly referenced by the candidate matching data segment 1 is a candidate matched data segment 7, a location of the 1^{st} byte in the candidate matching data segment 1 is 46 in a data group, and a location of a 1^{st} byte in the candidate matched data segment 7 is 39 in the data group. In this case, a candidate distance between the candidate matching data segment 1 and the candidate matched data segment 7 is 6, in other words, a quantity of bytes between the 1^{st} byte in the candidate matching data segment 1 and the 1^{st} byte in the candidate matched data segment 7 is 6. If the candidate matched data segment 7 belongs to a candidate matching data segment 8, and a candidate matched data segment 9 is directly referenced by the candidate matching data segment 8, the candidate matched data segment 9 is indirectly referenced by the candidate matching data segment 1. A location of a byte that is in the candidate matched data segment 9 and that corresponds to the 1^{st} byte in the candidate matching data segment 1 is 25, and in this case, a candidate distance between the candidate matching data segment 1 and the candidate matched data segment 9 is 20.

After the at least one candidate distance corresponding to each candidate matching data segment is determined, whether each candidate matching data segment can be determined as a matching data segment may be determined based on a relative value relationship between the candidate distance and the reference distance. For any candidate matching data segment, if at least one candidate distance corresponding to the candidate matching data segment is greater than the reference distance, it may be considered that if the candidate matching data segment is determined as a matching data segment, when a compressed segment obtained by compressing the matching data segment is decompressed, the matching data segment needs to be obtained through decompression based on a compressed segment corresponding to a non-matching data segment far away from the compressed segment, and this is difficult to ensure stability of the decompression. Therefore, the candidate matching data segment may be determined as the non-matching data segment. In a subsequent process of decompressing the non-matching data segment, the decompression may be implemented by using the non-matching data segment, to improve stability and efficiency of the decompression.

If there is a candidate distance less than or equal to the reference distance in the at least one candidate distance corresponding to the candidate matching data segment, the candidate matching data segment may be determined as the matching data segment, and a candidate matched data segment corresponding to the candidate distance less than or equal to the reference distance is determined as a matched data segment corresponding to the matching data segment. If there are a plurality of candidate distances less than or equal to the reference distance, a matched data segment with a shortest candidate distance may be determined as a matched data segment corresponding to the matching data segment.

In the symbol system provided in this embodiment of this application, the reference distance may be denoted as W. The reference distance functions similarly to a sliding window, and is for controlling a stable left boundary of each matching data segment. It can be learned from the foregoing descriptions that, in this embodiment of this application, logic for searching for the matched data segment is modified as follows: A premise for the matching data segment S[i..i+l] to complete matching is that for any k (0≤k<l), (i+k)-Ancestor[i+k]≤W. If this is not satisfied, the candidate matching data segment S[i..i+l] is re-determined as a non-matching data segment. In this embodiment of this application, the location array and the reference distance are introduced in the compression process, to control that each matching data segment can be decompressed by a matched data segment whose distance to the matching data segment is within the reference distance. In some cases, after the distance between the matching data segment and the matched data segment is controlled based on the location array, the location array may be deleted, to reduce space occupation.

In addition, in the data processing method provided in this embodiment of this application, when data is compressed, there is no need to consider a service feature of the data. The method can adapt to various scenarios in which data compression needs to be performed, and has strong scenario adaptability.

S403: Compress the plurality of data segments based on data segments referenced by the plurality of data segments to obtain first compressed data including a plurality of compressed segments, where each compressed segment is obtained by compressing a corresponding data segment, a data segment referenced by any matching data segment is a matched data segment having a same byte as the any matching data segment, and a data segment referenced by any non-matching data segment is the any non-matching data segment.

For a process of compressing the plurality of data segments and outputting the first compressed data including the plurality of compressed segments, refer to the foregoing process of compressing the plurality of data segments by using the LZ77-based general compression algorithm. Details are not described herein again. A storage location of the first compressed data obtained through compression is not limited in this embodiment of this application. For example, after the compression is completed, the data group before compression may be deleted, and the first compressed data obtained through compression is stored in a location originally for storing the data group, or the first compressed data may be stored in a location different from that of the data group. For example, in the data processing scenario shown in FIG. 5, the first compressed data may be stored in a storage block to which an original data group belongs, or may be independently stored in another location in the HOT. Regardless of whether the first compressed data is stored in the storage block or stored in another location (for example, a storage location indicated by ③ in FIG. 5) in the HOT, it needs to be ensured that any B+-tree index established based on the HOT can be referenced to the storage location of the first compressed data. If the storage location of the first compressed data is different from the storage location of the data group, a value of the RID also needs to be changed, so that a changed value of the RID indicates the storage location of the first compressed data. For example, in a process indicated by ④ in FIG. 5, a value of R2 corresponding to the data 2 in the B+-tree changes from a value pointing to a storage location of the data 2 in the data group (indicated by dashed line arrows) to a value pointing to a storage location of the data 2 in the first compressed data (indicated by solid line arrows). Correspondingly, a value of R3 corresponding to the data 3 in the B+-tree changes from a value pointing to a storage location of the data 3 in the data group (indicated by the dashed line arrows) to a value pointing to a storage location of the data 3 in the first compressed data (indicated by the solid line arrows).

To improve efficiency of a subsequent decompression process, locations of a plurality of matching data segments and a plurality of non-matching data segments may be recorded in the compression process, so that fast decompression can be performed in the decompression process based on the locations of the plurality of matching data segments and the locations of the plurality of non-matching data segments. Therefore, in a possible implementation, after the plurality of data segments are compressed based on the data segments referenced by the plurality of data segments, mapping information may be further generated, where the mapping information indicates mapping relationship between start locations of the plurality of data segments and start locations of the plurality of compressed segments. The mapping information may also be referred to as an anchor index (Anchor Index), and the mapping information may include a start location of each data segment in the plurality of data segments and a start location of each compressed segment corresponding to each data segment. Alternatively, to save space occupied by the mapping information, the mapping information may not include a location of each data segment and a location of each compressed segment, but includes a start location of at least one reference data segment and a start location of at least one reference compressed segment, where the at least one reference data segment is in one-to-one correspondence with the at least one reference compressed segment.

Optionally, the at least one reference data segment may be first determined in the data group, and then the at least one reference compressed segment corresponding to the at least one reference data segment is determined. The at least one reference data segment may be determined based on the size of the data group. For example, a first step of selecting a reference data segment may be determined based on the size of the data group, and the at least one reference data segment is determined in the data group based on the first step. The first step is a distance between two adjacent reference data segments. A size of the first step may be set based on experience or specified by a user. First steps corresponding to different data groups may be the same or different. For example, if the size of the data group is 8 KB, first data segments before compression whose distances to the start location of the data group are not less than 1 KB, 2 KB, ..., and 7 KB may be respectively determined by using 1 KB as the first step. The determined seven data segments are reference data segments, and a start location of each reference data segment may be recorded. Then, each reference compressed segment obtained by compressing each reference data segment needs to be determined, and a start location of each reference compressed segment in the first compressed data is recorded.

FIG. 7 is a diagram of mapping information. A length of the data group before compression is 18B, and is for determining a step 6B of the reference data segment. Therefore, a 1^{st} data segment BCD before compression whose distance to the start location of the data group is not less than 6B may be determined as one reference data segment, and a start location of the data segment BCD is recorded as 6 in the mapping information. Then, a 1^{st} data segment EA before compression to the start location of the data group is not less than 12B may be determined as another reference data segment, and a start location of the data segment EA is recorded as 13 in the mapping information.

An example in which a length of a compressed segment obtained by compressing the matching data segment is 1B is used. After the start location of the reference data segment BCD is determined, it may be determined that a reference compressed segment corresponding to the reference data segment BCD is (2, 3, 1), and a start location of the reference compressed segment (2, 3, 1) may be recorded as 7 in the mapping information. A reference compressed segment corresponding to the reference data segment EA is EA, and in this case, a start location of the reference compressed segment EA may be recorded as 10 in the mapping information.

Optionally, at least one reference compressed segment may alternatively be first determined in the first compressed data, and then at least one reference data segment corresponding to the at least one reference compressed segment is determined. The at least one reference compressed segment may be determined based on a size of the first compressed data obtained through compression. For example, a second step for selecting the reference compressed segment may be determined based on the size of the first compressed data, and the at least one reference compressed segment is determined in the first compressed data based on the second step. The second step is a distance between two adjacent reference compressed segments. A size of the second step may be set based on experience or specified by a user. Second steps corresponding to first compressed data of different sizes may be the same or different. For example, if the size of the data group is 4 KB, first compressed segments after compression whose distances to the start location of the first compressed data are not less than 1 KB, 2 KB, and 3 KB may be respectively determined by using 1 KB as the first step. The determined three compressed segments are reference compressed segments, and a start location of each reference compressed segment may be recorded. Then, a reference data segment of each reference compressed segment obtained through compression needs to be determined, and a start location of each reference data segment in the data group is recorded.

In some cases, regardless of whether the mapping information records the start locations of each data segment and each compressed segment or start locations of the at least one reference data segment and the at least one reference compressed segment, the start locations can all be represented by using the symbol system provided in this embodiment of this application. In the symbol system, the start location of each data segment or the start location of the at least one reference data segment may be represented by AS, and the start location of each compressed segment or the start location of the at least one reference compressed segment may be represented by AD.

In this case, a distribution feature of the start location in the mapping information may be represented by using an ordered binary array, that is, a mapping relationship between the start location of the data segment and the start location of the data segment of the corresponding compressed segment may be recorded by using an ordered binary array. The ordered binary array may be represented as <AS, AD> or <AD, AS>.

Because the mapping information can indicate the mapping relationships between the start locations of the plurality of data segments and the start locations of the plurality of compressed segments, a start location of a compressed segment corresponding to a start location of any data segment can be efficiently determined based on the mapping information in a decompression process, or a start location of a data segment corresponding to a start location of any compressed segment can be efficiently determined.

It can be learned from the foregoing descriptions of the data compression method in the data processing method provided in this embodiment of this application that, in this embodiment of this application, after compression, not only the first compressed data obtained through the compression can be output, but also the mapping information can be output. Therefore, when content output after compression is completed is stored, a storage format needs to be determined based on a format of the output content, and the output content needs to be persistently stored based on the storage format. For example, the output content includes two parts: the first compressed data and the mapping information, and in this case, the storage format may be a format in which the first compressed data and the mapping information are separately stored or a format in which the first compressed data and the mapping information are stored together. For different data processing scenarios, different storage formats may be determined. For example, in the HOT-based data processing scenario shown in FIG. 5, the storage format may be a format in which the first compressed data and the mapping information are stored together. In the LSM-tree-based data processing scenario shown in FIG. 6, the storage format may be a format in which the first compressed data and the mapping information are separately stored. The first compressed data may be stored in the SSTable, and the mapping information may be stored in the MemTable.

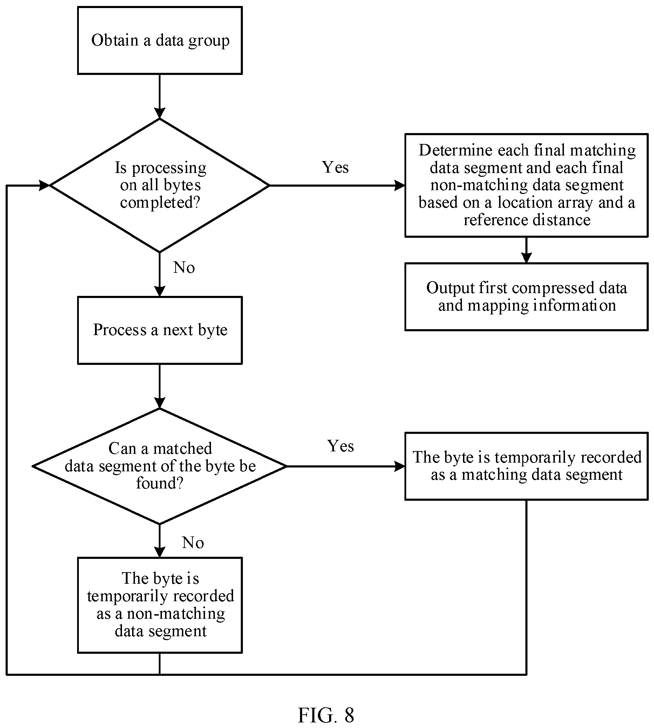

For example, FIG. 8 is a schematic flowchart of data compression. First, a data group is obtained, and whether processing on all bytes is completed is determined. If processing on all bytes is not completed, a next byte is processed. Whether a matched data segment of the byte can be found is determined. If the matched data segment of the byte can be found, the byte is temporarily recorded as a matching data segment. If the matched data segment of the byte cannot be found, the byte is temporarily recorded as a non-matching data segment. If processing on all bytes is completed, each final matching data segment and each final non-matching data segment are determined based on a location array and a reference distance, and first compressed data and mapping information are output.

In this application, the distance between the matching data segment and the matched data segment in the data group is controlled to be less than or equal to the reference distance, so that during decompression, decompression of each compressed segment that needs to be decompressed can be implemented based on a compressed segment corresponding to a data segment whose distance to each data segment does not exceed the reference distance. Therefore, before the decompression, a boundary of the compressed data that needs to be decompressed can be determined based on the reference distance, and the compressed data is decompressed in the boundary. In this way, stable decompression performance can be ensured.

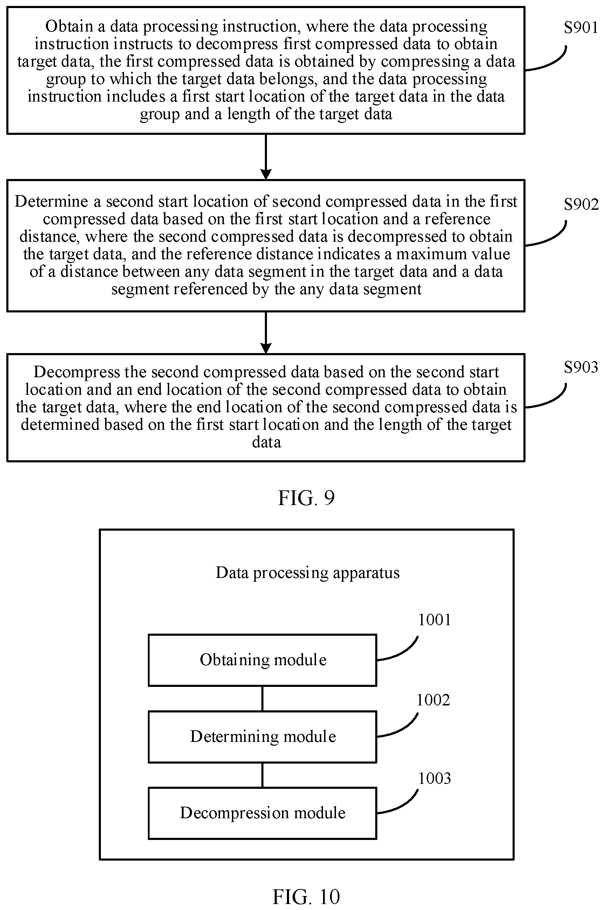

The foregoing describes the data compression process in the data processing method provided in this embodiment of this application. The following describes a data decompression process corresponding to the data compression process. For example, FIG. 9 is a schematic flowchart of data decompression. A data decompression process includes but is not limited to the following S901 to S903.

S901: Obtain a data processing instruction, where the data processing instruction instructs to decompress first compressed data to obtain target data, the first compressed data is obtained by compressing a data group to which the target data belongs, and the data processing instruction includes a first start location of the target data in the data group and a length of the target data.

The target data may be partial data in the data group or all data in the data group. In this embodiment of this application, a decompression process in which the target data is partial data in the data group is temporarily described.

It can be learned from the foregoing descriptions that the data group may be stored in a HOT, and the data group includes a plurality of pieces of data in a storage block of the HOT. In this case, the target data may include at least one piece of data in the plurality of pieces of data.

In an LSM-tree-based data processing environment, the data group may alternatively be stored in a baseline database of an LSM-tree. To control a read access discreteness problem and reduce maintenance costs of an incremental data change, in the LSM-tree-based data processing environment, a chunk is used as a minimum unit for I/O write, and a storage block is used as a minimum unit for I/O read. Therefore, the data group includes data in a plurality of storage blocks in a chunk in the baseline database, and the target data may include data in at least one of the plurality of storage blocks.

In addition, in the LSM-tree-based data processing environment, a storage block with high read frequency may be stored in a block cache (Block Cache). For example, refer to FIG. 6. A block cache shown in ② in FIG. 6 is for caching a storage block with high access frequency. In some cases, in a data reading process indicated by ③ in FIG. 6, data read may be performed in a unit of a storage block.

A method for obtaining the data processing instruction is not limited in this embodiment of this application. For example, when the target data needs to be obtained in a service running process, a device may autonomously generate the data processing instruction that instructs to decompress the first compressed data to obtain the target data, so as to obtain the data processing instruction. Alternatively, the device may receive a data processing instruction sent by another device or entered by a user, to obtain the data processing instruction.

If the data processing instruction is autonomously generated by the device, before generating the data processing instruction, the device may first obtain the first start location of the target data in the data group and the length of the target data. A HOT-based data processing environment is used as an example. Search may be performed based on K corresponding to the target data by using a B+-tree index, to determine an RID corresponding to the target data, determine the first start location of the target data in the data group based on the RID, and determine the length of the target data based on a length of the at least one piece of data included in the target data.

In the symbol system provided in this embodiment of this application, the first start location of the target data may be represented as OFF, and the length of the target data may be represented as (size, SZ).

S902: Determine a second start location of second compressed data in the first compressed data based on the first start location and a reference distance, where the second compressed data is decompressed to obtain the target data, and the reference distance indicates a maximum value of a distance between any data segment in the target data and a data segment referenced by the any data segment.

A method for determining the second start location based on the first start location and the reference distance is not limited in this embodiment of this application. In a possible implementation, the data group includes a plurality of data segments, the first compressed data includes a plurality of compressed segments, and each compressed segment is obtained by compressing a corresponding data segment. In this implementation, a process of determining the second start location may include: obtaining a start location of each data segment in the data group; determining, in the plurality of data segments based on the start location of each data segment, a first data segment to which a first location belongs, where the first location is determined based on a difference between the first start location and the reference distance; determining, based on a start location of the first data segment, a start location of the first compressed segment obtained by compressing the first data segment; and determining the start location of the first compressed segment as the second start location.

The difference between the first start location and the reference distance can indicate the first location that is before the first start location and whose distance to the first start location is the reference distance. Because a distance between any data segment in the target data and a data segment referenced by the any data segment is less than or equal to the reference distance, in other words, a data segment referenced by any data segment in a target data segment is at the first location or after the first location, decompression starts from the start location of the first compressed segment corresponding to the first data segment to which the first location belongs. This can ensure that the target data is obtained through decompression.

In a possible implementation, obtaining the start location of each data segment in the data group may include: obtaining a length of each data segment; and determining the start location of each data segment in the data group based on the length of each data segment and an order of each compressed segment in the first compressed data, where an order of any data segment in the data group is the same as an order of a compressed segment that is in the first compressed data and that is obtained by compressing the any data segment.

Because the order of the any data segment in the data group is the same as the order of the compressed segment that is in the first compressed data and that is obtained by compressing the any data segment, an order of each data segment in the data group may be determined based on the order of each compressed segment in the first compressed data, and an initial location of each data segment in the data group is accurately determined based on the length of each data segment and the order of each data segment in the data group.

For example, because lengths of the plurality of data segments are stored in the plurality of compressed segments, the length of each data segment and the order of the compressed segments in the first compressed data may be determined by traversing each compressed segment, and an accumulated length of all data segments before each data segment are determined, so as to determine the start location of each data segment in the data group.

For example, the length of each data segment stored in the plurality of compressed segments is read, it is determined that a length of a 1^{st} data segment corresponding to a 1^{st} compressed segment is 3B, and it may be determined that a start location of the 1^{st} data segment in the data group is 0, and a start location of a 2^{nd} data segment corresponding to a 2^{nd} compressed segment in the data group is 3.

In a possible implementation, the first location the first data segment in the start locations of the plurality of data segments may be determined based on the difference between the first start location and the reference distance. For example, the difference between the first start location and the reference distance is calculated. If the difference is a value greater than or equal to 0, the difference may be determined as the first location. If the difference is less than 0, 0 may be determined as the first location. In other words, if the difference is a value greater than or equal to 0, it indicates that a location indicated by the difference is a location in the data group; or if the difference is a value less than 0, it indicates that the difference is not a location in the data group. This can also indicate that a distance between the first start location and a start location of the data group is less than or equal to the reference distance. Therefore, the start location of the data group may be determined as the first location, that is, 0 is determined as the first location.

In the symbol system provided in this embodiment of this application, the first location may be represented as TARGET_OFF, and a relationship between the first location and the first start location and the reference distance may be represented by TARGET_OFF=MAX(OFF-W, 0). MAX is a function for obtaining a maximum value.

After the start location of each data segment and the first location are determined, the first data segment to which the first location belongs may be determined in the plurality of data segments based on the start location of each data segment, to determine the start location of the first data segment. For example, in the start locations of the data segments, a start location A that is closest to the first location and that is less than or equal to the first location may be determined, and a start location B that is closest to the first location and that is greater than or equal to the first location may be determined.

If both the start location A and the start location B are the same as the first location, it indicates that the first location is the start location of the first data segment, and a data segment whose start location is the first location may be determined as the first data segment. If the start location A is different from the start location B, the start location A is less than the first location, and the start location B is greater than the first location, it indicates that the first location is in a data segment whose start location is the start location A, and the data segment whose start location is the start location A may be determined as the first data segment. If the start location A is different from the start location B, and either the start location A or the start location B is the same as the first location, a data segment corresponding to a start location that is the same as the first location may be determined as the first data segment.

In a possible implementation, determining, based on the start location of the first data segment, the start location of the first compressed segment obtained by compressing the first data segment includes: obtaining mapping information, where the mapping information indicates mapping relationships between the start locations of the plurality of data segments and start locations of the plurality of compressed segments; and determining the start location of the first compressed segment based on the mapping information and the start location of the first data segment. The mapping information is mapping information generated in the compression process. Because content included in the mapping information may be the start location of each data segment and the start location of each compressed segment, and may alternatively be a start location of at least one reference data segment and a start location of at least one reference compressed segment, for different content included in the mapping information, determining the start location of the first compressed segment based on the mapping information and the start location of the first data segment may have different cases, for example, the following cases A1 and A2.

Case A1: The mapping information includes the start location of each data segment and the start location of each compressed segment. In Case A1, in a process of determining the start location of the first compressed segment based on the mapping information and the start location of the first data segment, the start location of the first compressed segment having a mapping relationship with the first data segment may be directly found based on the start location of the first data segment. For example, in some cases, the mapping information stores a 2-tuple corresponding to the start location of each data segment and the start location of each compressed segment. In this case, a 2-tuple <AS1, AD1> or a 2-tuple <AD1, AS1> to which the start location AS1 of the first data segment belongs may be found in the 2-tuples. AD1 in the 2-tuple is the start location of the first compressed segment, and the start location of the first compressed segment is the second start location of the second compressed data.

Case A2: The mapping information includes the start location of the at least one reference data segment in the plurality of data segments and the start location of the at least one reference compressed segment obtained by compressing the at least one reference data segment. In Case A2, in a process of determining the start location of the first compressed segment based on the mapping information and the start location of the first data segment, a first reference data segment is determined in the at least one reference data segment based on the start location of the first data segment and the start location of the at least one reference data segment, where the first reference data segment is a reference data segment that is before the first data segment and that is closest to the first data segment; and a start location of a first reference compressed segment corresponding to the first reference data segment is determined as the start location of the first compressed segment.

An example in which the mapping information stores a 2-tuple corresponding to the start location of the at least one reference data segment and the start location of the at least one reference compressed segment is used. The first reference data segment that is closest to the start location AS1 of the first data segment and that is after the first data segment may be found based on the start location of the at least one reference data segment in the 2-tuples. A start location of the first reference data segment is AS2, and the start location AD2 of the first reference compressed segment is determined based on a 2-tuple <AS2, AD2> or a 2-tuple <AD2, AS2> to which AS2 belongs. The start location AD2 of the first reference compressed segment is the start location of the first compressed segment, and the start location of the first compressed segment is the second start location of the second compressed data.

S903: Decompress the second compressed data based on the second start location and an end location of the second compressed data to obtain the target data, where the end location of the second compressed data is determined based on the first start location and the length of the target data.

In a possible implementation, before the second compressed data is decompressed based on the second start location and the end location of the second compressed data to obtain the target data, the end location of the second compressed data further needs to be determined. A method for determining the end location of the second compressed data is not limited in this embodiment of this application. For example, a second data segment to which a second location belongs may be determined in the plurality of data segments based on the start location of each data segment, where the second location is a sum of the first start location and the length of the target data; a start location of a third data segment adjacent to the second data segment is determined in the start locations of the data segments, where the third data segment is after the second data segment; a start location of a second compressed segment corresponding to the third data segment is determined based on the start location of the third data segment; and the start location of the second compressed segment is determined as the end location of the second compressed data.

The sum of the first start location and the length of the target data can indicate an end location of the target data in the data group, in other words, the second location can indicate an end location of the target data in the data group. The second data segment to which the second location belongs is a data segment to which the end location of the target data belongs. Therefore, the start location of the third data segment that is adjacent to the second data segment and that is after the second data segment is after the end location of the target data, and decompression is stopped at the start location of the second compressed segment corresponding to the third data segment. In this way, the target data can be completely decompressed.

In a possible implementation, for a method for determining, in the plurality of data segments based on the start location of each data segment, the second data segment to which the second location belongs, refer to the method for determining, in the plurality of data segments based on the start location of each data segment, the first data segment to which the first location belongs in S902. Details are not described herein again.

After the second data segment is determined, a third data segment that is after the second data segment and that is adjacent to the second data segment may be determined, and a start location of the third data segment is determined in the start locations of the data segments, so that a start location of a second compressed segment corresponding to the third data segment may be determined based on the start location of the third data segment. The second compressed segment corresponding to the third data segment may be a compressed segment obtained by compressing the third data segment, or may be a reference compressed segment corresponding to a reference data segment that is closest to the third data segment and that is after the third data segment. For a method for determining the start location of the second compressed segment based on the start location of the third data segment, refer to the method for determining the start location of the first compressed segment based on the start location of the first data segment in S902. Details are not described herein again. The determined start location of the second compressed segment is the end location of the second compressed data.

After the second start location and the end location of the second compressed data are determined, the second compressed data may be decompressed based on the second start location and the end location of the second compressed data to obtain the target data. In some cases, a data range of the second compressed data is greater than a data range of the target data. In other words, data obtained by decompressing the second compressed data includes the target data and data other than the target data. In this case, decompressing the second compressed data based on the second start location and the end location of the second compressed data to obtain the target data includes: decompressing the second compressed data based on the second start location and the end location of the second compressed data to obtain intermediate data; determining the end location of the target data based on the first start location and the length of the target data; and extracting the target data from the intermediate data based on the first start location and the end location of the target data.

Optionally, for a process of performing decompression based on the second start location and the end location of the second compressed data to obtain the intermediate data, refer to the foregoing descriptions of the general data decompression process based on the LZ77. Details are not described herein again. In addition, in a possible implementation, the decompression on the second compressed data may alternatively start from the second start location, and after decompression of each compressed segment is completed, an end location of a data segment obtained by decompressing each compressed segment is recorded. When a recorded end location of a data segment is greater than or equal to the second location, the decompression is stopped to obtain the intermediate data.

The intermediate data obtained through decompression includes the target data, and therefore, the target data may be obtained by extracting the intermediate data. A start location of the target data is the first start location. Therefore, before the target data is extracted, the end location of the target data further needs to be determined. For example, the sum of the first start location and the length of the target data may be determined as the end location of the target data. For example, if the first start location is 9 and the length of the target data is 56B, it may be determined that the end location of the target data is 64, and data between the first start location 9 and the end location 64 may be extracted from the first data to obtain the target data.

In a possible implementation, the intermediate data includes a compressed segment that is not referenced by any data segment in the target data, and a compressed segment referenced by the compressed segment is outside the intermediate data, to be specific, a compressed segment referenced by the compressed segment is before the second start location. As a result, the compressed segment cannot be decompressed and restored. However, because a compressed segment that cannot be decompressed and restored is not reference by each data segment in the target data, even if the compressed segment that cannot be decompressed and restored exists in the intermediate data, obtaining of the target data is not affected.

In addition, in this application, when partial data needs to be queried or invoked (for example, singlepoint query is performed on a data segment or a field), there is no need to decompress all compressed data. In this way, decompression efficiency is improved, a waste of resources is reduced, and impact on running efficiency of a service for which data invoking or query needs to be performed is avoided.

In conclusion, because the reference distance indicates a maximum value of a distance between any data segment in the target data and a data segment referenced by the any data segment, a data segment referenced by each data segment in the target data may be in the target data, or may be in partial data whose distance to the first start location is less than or equal to the reference distance. Therefore, the second start location of the second compressed data decompressed to obtain the target data can be determined based on the first start location and the reference distance, and it is ensured that the target data can be obtained by decompressing the second compressed data from the second start location. In addition, the end location of the second compressed data can be accurately determined based on the first start location and the length of the target data, and stopping the decompression at the end location of the second compressed data not only can ensure that data obtained through decompression includes the target data, but also can avoid decompression of compressed data that does not need to be decompressed, thereby improving decompression efficiency and reducing a waste of resources.

In this application, the determined second start location and the determined end location of the second compressed data are used as a decompression boundary, so that decompression performance of decompression performed based on a clear decompression boundary is stable.

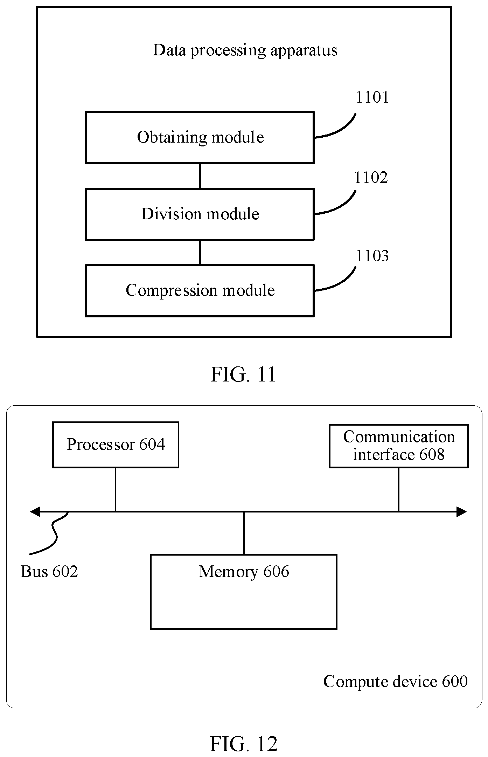

The foregoing describes the data processing method in embodiments of this application. In correspondence to the foregoing method, an embodiment of this application further provides a data processing apparatus. FIG. 10 or FIG. 11 is a diagram of a structure of a data processing apparatus according to an embodiment of this application. The apparatus may implement the foregoing data processing method by software, hardware, or a combination thereof. The apparatus may be used in a device that provides a cloud computing service. It should be understood that the apparatus may include more additional modules than the shown modules or some of the shown modules may be omitted. This is not limited in embodiments of this application.

As shown in FIG. 10, the data processing apparatus includes:
an obtaining module 1001, configured to obtain a data processing instruction, where the data processing instruction instructs to decompress first compressed data to obtain target data, the first compressed data is obtained by compressing a data group to which the target data belongs, and the data processing instruction includes a first start location of the target data in the data group and a length of the target data; a determining module 1002, configured to determine a second start location of second compressed data in the first compressed data based on the first start location and a reference distance, where the second compressed data is decompressed to obtain the target data, and the reference distance indicates a maximum value of a distance between any data segment in the target data and a data segment referenced by the any data segment; and a decompression module 1003, configured to decompress the second compressed data based on the second start location and an end location of the second compressed data to obtain the target data, where the end location of the second compressed data is determined based on the first start location and the length of the target data.

In a possible implementation, the first compressed data includes a plurality of compressed segments, the data group includes a plurality of data segments, and each compressed segment is obtained by compressing a corresponding data segment. The determining module 1002 is configured to: obtain a start location of each data segment in the data group; determine, in the plurality of data segments based on the start location of each data segment, a first data segment to which a first location belongs, where the first location is determined based on a difference between the first start location and the reference distance; determine, based on a start location of the first data segment, a start location of a first compressed segment corresponding to the first data segment; and determine the start location of the first compressed segment as the second start location.

In a possible implementation, the determining module 1002 is configured to: obtain a length of each data segment; and determine the start location of each data segment in the data group based on the length of each data segment and an order of each compressed segment in the first compressed data, where an order of any data segment in the data group is the same as an order of a compressed segment that is in the first compressed data and that is obtained by compressing the any data segment.

In a possible implementation, the determining module 1002 is configured to: obtain mapping information, where the mapping information indicates mapping relationships between start locations of the plurality of data segments and start locations of the plurality of compressed segments; and determine the start location of the first compressed segment based on the mapping information and the start location of the first data segment.

In a possible implementation, the mapping information includes a start location of at least one reference data segment in the plurality of data segments and a start location of at least one reference compressed segment obtained by compressing the at least one reference data segment. The determining module 1002 is configured to: determine a first reference data segment in the at least one reference data segment based on the start location of the first data segment and the start location of the at least one reference data segment, where the first reference data segment is a reference data segment that is before the first data segment and that is closest to the first data segment; and determine, as the start location of the first compressed segment, a start location of a first reference compressed segment obtained by compressing the first reference data segment.

In a possible implementation, the determining module 1002 is further configured to: determine, in the plurality of data segments based on the start location of each data segment, a second data segment to which a second location belongs, where the second location is a sum of the first start location and the length of the target data; determine, in the start locations of the data segments, a start location of a third data segment adjacent to the second data segment, where the third data segment is after the second data segment; determine, based on the start location of the third data segment, a start location of a second compressed segment corresponding to the third data segment; and determine the start location of the second compressed segment as the end location of the second compressed data.

In a possible implementation, the decompression module 1003 is configured to: decompress the second compressed data based on the second start location and the end location of the second compressed data, to obtain intermediate data; determine an end location of the target data based on the first start location and the length of the target data; and extract the target data from the intermediate data based on the first start location and the end location of the target data.

In a possible implementation, the data group is stored in a HOT, the data group includes a plurality of pieces of data in a storage block of the HOT, and the target data includes at least one piece of data in the plurality of pieces of data.

In a possible implementation, the data group is stored in a baseline database of an LSM-tree, the data group includes data in a plurality of storage blocks in the baseline database, and the target data includes data in at least one of the plurality of storage blocks.

As shown in FIG. 11, the data processing apparatus includes:
an obtaining module 1101, configured to obtain a data group, where the data group includes a plurality of bytes; a division module 1102, configured to divide the plurality of bytes into a plurality of data segments, where the plurality of data segments include at least one of a matching data segment or a non-matching data segment, a byte in the non-matching data segment is different from a byte in each data segment before the non-matching data segment, a byte in the matching data segment is the same as a byte in a matched data segment before the matching data segment, and a distance between the matching data segment and the matched data segment is less than or equal to a reference distance; and a compression module 1103, configured to: compress the plurality of data segments based on data segments referenced by the plurality of data segments to obtain first compressed data including a plurality of compressed segments, where each compressed segment is obtained by compressing a corresponding data segment, a data segment referenced by any matching data segment is a matched data segment having a same byte that in the any matching data segment, and a data segment referenced by any non-matching data segment is the any non-matching data segment.

In a possible implementation, the division module 1102 is configured to: divide the plurality of bytes into a plurality of candidate data segments, where the plurality of candidate data segments include at least one of a candidate matching data segment or a non-matching data segment, and a byte in the candidate matching data segment is the same as a byte in at least one candidate matched data segment before the candidate matching data segment; obtain a location array of the candidate matching data segment, where the location array includes a location of the candidate matching data segment and a location of the at least one candidate matched data segment corresponding to the candidate matching data segment; and in a case in which there is a candidate distance less than or equal to the reference distance in at least one candidate distance, determine the candidate matching data segment as the matching data segment, where the at least one candidate distance is determined based on the location of the candidate matching data segment and the location of the at least one candidate matched data segment; or in a case in which the at least one candidate distance is greater than the reference distance, determine the candidate matching data segment as the non-matching data segment.

In a possible implementation, the apparatus further includes a generation module, and the generation module is configured to generate mapping information, where the mapping information indicates mapping relationships between start locations of the plurality of data segments and start locations of the plurality of compressed segments.

In a possible implementation, the data group is stored in a HOT, and the data group includes a plurality of pieces of data in a storage block of the HOT.

In a possible implementation, the data group is stored in a baseline database of an LSM-tree, and the data group includes data in a plurality of storage blocks in the baseline database.

It should be understood that, when the apparatus provided in FIG. 10 or FIG. 11 implement functions of the apparatus, division into the functional modules is merely used as an example for description. In an actual application, the foregoing functions may be allocated to different functional modules for implementation based on a requirement. In other words, an internal structure of a device is divided into different functional modules, to implement all or some of the functions described above. In addition, the apparatuses provided in the foregoing embodiments and the method embodiments pertain to the same concept. For specific implementation processes of the apparatuses, refer to the method embodiments. Details are not described herein again.

This application further provides a compute device that can be configured as a server in the foregoing implementation environment. FIG. 12 is a diagram of a hardware structure of a compute device according to an embodiment of this application. As shown in FIG. 12, the compute device 600 includes a bus 602, a processor 604, a memory 606, and a communication interface 608. The processor 604, the memory 606, and the communication interface 608 communicate with each other through the bus 602. It should be understood that a quantity of processors and a quantity of memories in the compute device 600 are not limited in this application.

The bus 602 may be a peripheral component interconnect (peripheral component interconnect, PCI) bus, an extended industry standard architecture (extended industry standard architecture, EISA) bus, or the like. The bus may include an address bus, a data bus, a control bus, and the like. For ease of representation, only one line is used in FIG. 12 for representation, but it does not indicate that there is only one bus or only one type of bus. The bus 602 may include a path for information transmission between the components (for example, the memory 606, the processor 604, and the communication interface 608) of the compute device 600.

The processor 604 may include any one or more of processors, such as a central processing unit (central processing unit, CPU), a graphics processing unit (graphics processing unit, GPU), a microprocessor (microprocessor, MP), or a digital signal processor (digital signal processor, DSP).

The memory 606 may include a volatile memory (volatile memory), for example, a random access memory (random access memory, RAM). The processor 604 may further include a non-volatile memory (non-volatile memory), for example, a read-only memory (read-only memory, ROM), a flash memory, a hard disk drive (hard disk drive, HDD), or a solid-state drive (solid-state drive, SSD).

The memory 606 stores executable program code, and the processor 604 executes the executable program code to separately implement functions of the foregoing modules, so as to implement a data processing method. In other words, the memory 606 stores instructions for performing the data processing method.

The communication interface 608 uses a transceiver module, for example, but not limited to, a network interface card or a transceiver, to implement communication between the compute device 600 and another device or a communication network.

An embodiment of this application further provides a compute device cluster. The compute device cluster includes at least one compute device. The compute device may be configured as a server in the foregoing implementation environment, for example, a central server, an edge server, or a local server in a local data center.

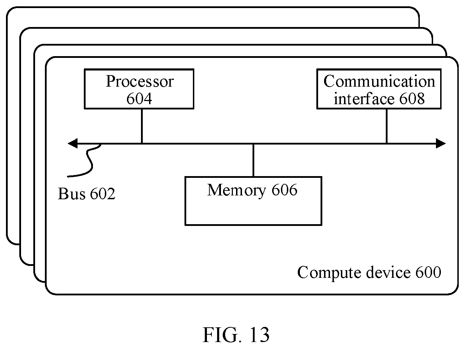

FIG. 13 is a diagram of a structure of a compute device cluster according to an embodiment of this application. As shown in FIG. 13, the compute device cluster includes at least one compute device 600. A memory 606 in one or more compute devices 600 in the compute device cluster may store same instructions for performing a data processing method.

In some possible implementations, alternatively, the memory 606 in the one or more compute devices 600 in the compute device cluster may respectively store some instructions for performing the data processing method. In other words, a combination of the one or more compute devices 600 may collectively execute the instructions for performing the data processing method.

It should be noted that memories 606 in different compute devices 600 in the compute device cluster may store different instructions, and are respectively configured to perform some of functions of a data processing apparatus. To be specific, the instructions stored in the memories 606 in the different compute devices 600 may be for implementing functions of one or more modules.

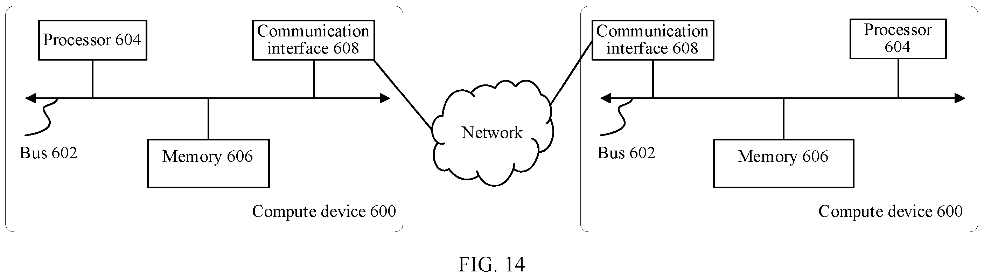

In some embodiments, the one or more compute devices in the compute device cluster may be connected through a network. The network may be a wide area network, a local area network, or the like. FIG. 14 is a diagram of a connection manner of a compute device cluster according to an embodiment of this application. As shown in FIG. 14, two compute devices 600 are connected through a network. Specifically, each compute device is connected to the network through a communication interface in the compute device.

It should be understood that a function of the compute device 600 shown in FIG. 14 may alternatively be completed by a plurality of compute devices 600.

An embodiment of this application further provides a computer program product including instructions. The computer program product may be software or a program product that includes the instructions and that can run on a compute device or be stored in any usable medium. When the computer program product runs on at least one compute device, the at least one compute device is caused to perform a data processing method.

An embodiment of this application further provides a computer-readable storage medium. The computer-readable storage medium may be any usable medium that can be stored in a compute device, or a data storage device, for example, a data center, including one or more usable media. The usable medium may be a magnetic medium (for example, a floppy disk, a hard disk drive, or a magnetic tape), an optical medium (for example, a DVD), a semiconductor medium (for example, a solid-state drive), or the like. The computer-readable storage medium includes instructions, and the instructions instruct a compute device to perform a data processing method.

All or some of the foregoing embodiments may be implemented by software, hardware, firmware, or any combination thereof. When software is used to implement the foregoing embodiments, all or some of the foregoing embodiments may be implemented in a form of a computer program product. The computer program product includes one or more computer instructions. When the computer program instructions are loaded and executed on a computer, all or some of the procedures or functions according to this application are generated. The computer may be a generalpurpose computer, a dedicated computer, a computer network, or another programmable apparatus. The computer instructions may be stored in the computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by the computer, or a data storage device, for example, a server or a data center, including one or more usable media. The usable medium may be a magnetic medium (for example, a floppy disk, a hard disk, or a magnetic tape), an optical medium (for example, a DVD), a semiconductor medium (for example, a solid-state drive Solid-State Drive), or the like.

The terms such as "first" and "second" in this application are used to distinguish between same or similar items with basically same roles and functions. It should be understood that there is no logical or timing dependency between "first", "second", and "nth", and neither a quantity nor an execution sequence is limited. It should also be understood that although the following descriptions use terms such as "first" and "second" to describe various elements, these elements should not be limited by the terms. These terms are simply used to distinguish one element from another.

It should be further understood that sequence numbers of the processes do not mean execution sequences in embodiments of this application. The execution sequences of the processes should be determined based on functions and internal logic of the processes, and should not constitute any limitation on implementation processes of embodiments of this application.

The term "at least one" in this application means one or more, and the term "a plurality of" in this application means two or more. For example, a plurality of second devices means two or more second devices. The terms "system" and "network" are often used interchangeably herein.

It should be understood that the terms used in the descriptions of the various examples herein are merely intended to describe specific examples and are not intended to impose a limitation. The terms "one" ("a" and "an") and "the" of singular forms used in the descriptions of the various examples and the appended claims are also intended to include plural forms, unless otherwise specified in the context clearly.

It should further be understood that the term "and/or" used in this specification indicates and includes any or all possible combinations of one or more of the associated listed items. The term "and/or" describes an association relationship between associated objects and represents that three relationships may exist. For example, A and/or B may represent the following three cases: Only A exists, both A and B exist, and only B exists. In addition, the character "/" in this application generally indicates an "or" relationship between the associated objects.

It should be further understood that the term "if" may be interpreted as a meaning of "when" ("when" or "upon") or "in response to determining" or "in response to detecting". Similarly, based on the context, the phrase "if it is determined that" or "if [a stated condition or event] is detected" may be interpreted as a meaning of "when it is determined that" or "in response to determining" or "when [a stated condition or event] is detected" or "in response to detecting [a stated condition or event]".

The foregoing descriptions are merely specific implementations of this application, but are not intended to limit the protection scope of this application. Any equivalent modification or replacement readily figured out by a person skilled in the art within the technical scope disclosed in this application shall fall within the protection scope of this application. Therefore, the protection scope of this application shall be subject to the protection scope of the claims.

All or some of the foregoing embodiments may be implemented by software, hardware, firmware, or any combination thereof. When software is used to implement the foregoing embodiments, all or some of the foregoing embodiments may be implemented in a form of program structure information. The program structure information includes one or more program instructions. When the program instructions are loaded and executed on a compute device, all or some of the procedures or functions according to embodiments of this application are generated.

A person of ordinary skill in the art may understand that all or some of the steps of embodiments may be implemented by hardware or a program instructing related hardware. The program may be stored in a computer-readable storage medium. The storage medium may include a read-only memory, a magnetic disk, an optical disc, or the like.

It should be noted that information (including but not limited to user equipment information, user personal information, and the like), data (including but not limited to data for analysis, data for storage, data for display, and the like), and signals in this application are all authorized by users or fully authorized by all parties, and collection, use, and processing of related data need to comply with related laws, regulations, and standards of related countries and regions. For example, data and the like in this application is obtained under full authorization.

Finally, it should be noted that the foregoing embodiments are merely intended for describing the technical solutions of this application, but not for limiting this application. Although this application is described in detail with reference to the foregoing embodiments, a person of ordinary skill in the art should understand that modifications may still be made to the technical solutions described in the foregoing embodiments or equivalent replacements may be made to some technical features, and such modifications and replacements do not cause the essence of the corresponding technical solutions to depart from the protection scope of technical solutions of embodiments of this application.

## Claims

1. A data processing method, wherein the method comprises:
obtaining a data processing instruction, wherein the data processing instruction instructs to decompress first compressed data to obtain target data, the first compressed data is obtained by compressing a data group to which the target data belongs, and the data processing instruction comprises a first start location of the target data in the data group and a length of the target data;
determining a second start location of second compressed data in the first compressed data based on the first start location and a reference distance, wherein the second compressed data is decompressed to obtain the target data, and the reference distance indicates a maximum value of a distance between any data segment in the target data and a data segment referenced by the any data segment; and
decompressing the second compressed data based on the second start location and an end location of the second compressed data to obtain the target data, wherein the end location of the second compressed data is determined based on the first start location and the length of the target data.

2. The method according to claim 1, wherein the first compressed data comprises a plurality of compressed segments, the data group comprises a plurality of data segments, and each compressed segment is obtained by compressing a corresponding data segment; and the determining the second start location of the second compressed data in the first compressed data based on the first start location and the reference distance comprises:
obtaining a start location of each data segment in the data group;
determining, in the plurality of data segments based on the start location of each data segment, a first data segment to which a first location belongs, wherein the first location is determined based on a difference between the first start location and the reference distance;
determining, based on a start location of the first data segment, a start location of a first compressed segment corresponding to the first data segment; and
determining the start location of the first compressed segment as the second start location.

3. The method according to claim 2, wherein the obtaining the start location of each data segment in the data group comprises:
obtaining a length of each data segment; and
determining the start location of each data segment in the data group based on the length of each data segment and an order of each compressed segment in the first compressed data, wherein an order of any data segment in the data group is the same as an order of a compressed segment that is in the first compressed data and that is obtained by compressing the any data segment.

4. The method according to claim 2 or 3, wherein the determining, based on the start location of the first data segment, the start location of the first compressed segment corresponding to the first data segment comprises:
obtaining mapping information, wherein the mapping information indicates mapping relationships between start locations of the plurality of data segments and start locations of the plurality of compressed segments; and
determining the start location of the first compressed segment based on the mapping information and the start location of the first data segment.

5. The method according to claim 4, wherein the mapping information comprises a start location of at least one reference data segment in the plurality of data segments and a start location of at least one reference compressed segment obtained by compressing the at least one reference data segment; and the determining the start location of the first compressed segment based on the mapping information and the start location of the first data segment comprises:
determining a first reference data segment in the at least one reference data segment based on the start location of the first data segment and the start location of the at least one reference data segment, wherein the first reference data segment is a reference data segment that is before the first data segment and that is closest to the first data segment; and
determining, as the start location of the first compressed segment, a start location of a first reference compressed segment obtained by compressing the first reference data segment.

6. The method according to any one of claims 2 to 5, wherein before the decompressing the second compressed data based on the second start location and the end location of the second compressed data to obtain the target data, the method further comprises:
determining, in the plurality of data segments based on the start location of each data segment, a second data segment to which a second location belongs, wherein the second location is a sum of the first start location and the length of the target data;
determining, in the start locations of the data segments, a start location of a third data segment adjacent to the second data segment, wherein the third data segment is after the second data segment;
determining, based on the start location of the third data segment, a start location of a second compressed segment corresponding to the third data segment; and
determining the start location of the second compressed segment as the end location of the second compressed data.

7. The method according to any one of claims 1 to 6, wherein the decompressing the second compressed data based on the second start location and the end location of the second compressed data to obtain the target data comprises:
decompressing the second compressed data based on the second start location and the end location of the second compressed data to obtain intermediate data;
determining an end location of the target data based on the first start location and the length of the target data; and
extracting the target data from the intermediate data based on the first start location and the end location of the target data.

8. The method according to any one of claims 1 to 7, wherein the data group is stored in a heap-organized table HOT, the data group comprises a plurality of pieces of data in a storage block of the HOT, and the target data comprises at least one piece of data in the plurality of pieces of data.

9. The method of any one of claims 1 to 7, wherein the data group is stored in a baseline database of a log-structured merge tree, the data group comprises data in a plurality of storage blocks in the baseline database, and the target data comprises data in at least one of the plurality of storage blocks.

10. A data processing apparatus, wherein the apparatus comprises:
an obtaining module, configured to obtain a data processing instruction, wherein the data processing instruction instructs to decompress first compressed data to obtain target data, the first compressed data is obtained by compressing a data group to which the target data belongs, and the data processing instruction comprises a first start location of the target data in the data group and a length of the target data;
a determining module, configured to determine a second start location of second compressed data in the first compressed data based on the first start location and a reference distance, wherein the second compressed data is decompressed to obtain the target data, and the reference distance indicates a maximum value of a distance between any data segment in the target data and a data segment referenced by the any data segment; and
a decompression module, configured to decompress the second compressed data based on the second start location and an end location of the second compressed data to obtain the target data, wherein the end location of the second compressed data is determined based on the first start location and the length of the target data.

11. The apparatus according to claim 10, wherein the first compressed data comprises a plurality of compressed segments, the data group comprises a plurality of data segments, and each compressed segment is obtained by compressing a corresponding data segment; and the determining module is configured to: obtain a start location of each data segment in the data group; determine, in the plurality of data segments based on the start location of each data segment, a first data segment to which a first location belongs, wherein the first location is determined based on a difference between the first start location and the reference distance; determine, based on a start location of the first data segment, a start location of a first compressed segment corresponding to the first data segment; and determine the start location of the first compressed segment as the second start location.

12. The apparatus according to claim 11, wherein the determining module is configured to: obtain a length of each data segment; and determine the start location of each data segment in the data group based on the length of each data segment and an order of each compressed segment in the first compressed data, wherein an order of any data segment in the data group is the same as an order of a compressed segment that is in the first compressed data and that is obtained by compressing the any data segment.

13. The apparatus according to claim 11 or 12, wherein the determining module is configured to: obtain mapping information, wherein the mapping information indicates mapping relationships between start locations of the plurality of data segments and start locations of the plurality of compressed segments; and determine the start location of the first compressed segment based on the mapping information and the start location of the first data segment.

14. The apparatus according to claim 13, wherein the mapping information comprises a start location of at least one reference data segment in the plurality of data segments and a start location of at least one reference compressed segment obtained by compressing the at least one reference data segment; and the determining module is configured to: determine a first reference data segment in the at least one reference data segment based on the start location of the first data segment and the start location of the at least one reference data segment, wherein the first reference data segment is a reference data segment that is before the first data segment and that is closest to the first data segment; and determine, as the start location of the first compressed segment, a start location of a first reference compressed segment obtained by compressing the first reference data segment.

15. The apparatus according to any one of claims 11 to 14, wherein the determining module is further configured to: determine, in the plurality of data segments based on the start location of each data segment, a second data segment to which a second location belongs, wherein the second location is a sum of the first start location and the length of the target data; determine, in the start locations of the data segments, a start location of a third data segment adjacent to the second data segment, wherein the third data segment is after the second data segment; determine, based on the start location of the third data segment, a start location of a second compressed segment corresponding to the third data segment; and determine the start location of the second compressed segment as the end location of the second compressed data.

16. The apparatus according to any one of claims 10 to 15, wherein the decompression module is configured to: decompress the second compressed data based on the second start location and the end location of the second compressed data to obtain intermediate data; determine an end location of the target data based on the first start location and the length of the target data; and extract the target data from the intermediate data based on the first start location and the end location of the target data.

17. The apparatus according to any one of claims 10 to 16, wherein the data group is stored in a heap-organized table HOT, the data group comprises a plurality of pieces of data in a storage block of the HOT, and the target data comprises at least one piece of data in the plurality of pieces of data.

18. The apparatus of any one of claims 10 to 16, wherein the data group is stored in a baseline database of a log-structured merge tree, the data group comprises data in a plurality of storage blocks in the baseline database, and the target data comprises data in at least one of the plurality of storage blocks.

19. A compute device cluster, wherein the compute device cluster comprises at least one compute device, each compute device comprises a processor, the processor is coupled to a memory, and the processor of the at least one compute device is configured to execute instructions stored in the memory of the at least one compute device, to cause the compute device cluster to perform the data processing method according to any one of claims 1 to 9.

20. A computer program product comprising instructions, wherein when the instructions are run by a compute device cluster, the compute device cluster is caused to perform the data processing method according to any one of claims 1 to 9.

21. A computer-readable storage medium, comprising computer program instructions, wherein when the computer program instructions are executed by a compute device cluster, the compute device cluster performs the data processing method according to any one of claims 1 to 9.
